# EUROPEAN PATENT APPLICATION

(11) **EP 2 660 632 A1**
(43) Date of publication of application: **06.11.2013**
(21) Application number: 11853338.9
(22) Date of filing: 27.12.2011
(51) Int. Cl.: G02B 5/08, B32B 27/00, G02B 1/10, H01L 31/042

(54) **FUNCTIONAL FILM, FILM MIRROR, AND REFLECTING DEVICE FOR SOLAR THERMAL POWER GENERATION**

(30) Priority: 28.12.2010 JP 2010291789
(71) Applicant: Konica Minolta, Inc., Tokyo 100-7015 (JP)
(72) Inventor: MOCHIZUKI, Makoto, Hachioji-shi Tokyo 192-8505 (JP)
(74) Representative: Gille Hrabal
(86) International application number: PCT/JP2011/080167
(87) International publication number: WO 2012/090987

(57) **Abstract**

A film mirror (10a) wherein a reflecting layer (5) is provided on a base material (3) is provided with: a corrosion preventing layer (6) composed of a silicone-modified resin, said corrosion preventing layer being laminated adjacent to the light reflecting side of the reflecting layer (5) by containing a silane coupling agent; and a hard coat layer (9), which is laminated on the outermost surface on the light reflecting side by containing an UV absorbent.

## Description

### TECHNICAL FIELD

The present invention relates to a functional film, film mirror, and reflecting device for solar thermal power generation using the film mirror.

### BACKGROUND ART

In recent years, various natural energies including biomass energy, nuclear energy, wind energy and solar energy have been investigated as substitutes for fossil fuel energy such as obtainable from petroleum and natural gas. Among them, solar energy is considered as a most stable and abundant natural energy as the substitutive energy for the fossil fuel energy. Solar energy which is a very promising substitutive energy is, however, supposed to be suffered from problems in (1) low energy density, and (2) difficulties in storage and transmission, from the viewpoint of actualization.

As challenges to the problems in solar energy, one solution ever proposed is a method of condensing solar energy using a huge reflecting device, aiming at overcoming the problem of low energy density from the viewpoint of utilizing the solar energy. Glass mirror has been used for the reflecting device since the reflecting device is exposed to ultraviolet radiation and heat of sunlight, wind, rain, sandstorm and so forth. The glass mirror, although it is excellent in environment-proof performance, is likely to be broken during transportation or needs a high-strength mount on which the mirror is mounted due to its large weight and thereby construction of a plant costs high.

On the other hand, film mirror has been known as a mirror for solar thermal power generation, characterized by its light weight, high flexibility, and low costs for manufacturing and transportation. Such a film mirror has a structure that a resin layer is laminated on a silver reflective layer provided on a film base (substrate) so as to suppress corrosion of silver. In addition, a resin layer containing a UV absorber is laminated over the layers to suppress degradation or a hard coat layer or the like is provided at the outermost surface to suppress scratching, so that durability of the film mirror may be improved.
Such a film mirror for solar thermal power generation is installed in the outdoor environment and therefore the mirror surface is periodically cleaned by high-pressure washing or brushing to prevent degradation in the reflectance due to adhesion of dust or the like. However, when such a film mirror which was exposed in the outdoors for a long time was cleaned in such a way, there was a problem that the reflectance was degraded due to delamination of the silver reflective layer and the anti-corrosion layer thereon caused by the stress occurred during the cleaning.
As explained above, a technique has been requested for a film mirror for solar thermal power generation to form an anti-corrosion layer having a high-adhesion capability with a silver reflective layer to prevent delaminating from the silver reflective layer caused by the stress occurred during a cleaning work.

A known report on the film mirror for solar thermal power generation is exemplified by Patent Literature 1. A film mirror disclosed in the literature has an acrylic layer containing a UV absorber provided at the outermost layer of the film so as to suppress the reflectance degradation due to discoloration of the resin layer caused by the UV exposure. In a case of the technique of the Patent Literature 1, however, a PET layer and a sticky layer are interposed between the silver layer and the acrylic layer and there was a problem that when the film mirror was cleaned by brushing after exposing the film mirror in the outdoors for more than half a year, the silver reflective layer and the PET layer were delaminated and it caused great degradation of reflectance.
According to a technique disclosed in Patent Literature 2, a hard coat layer of the outermost surface contains a large amount of UV absorber so as to suppress discoloration and fragility of the resin for the purpose of suppressing degradation of the resin layer caused by the UV exposure more strongly. However, when cleaned by brushing after exposing the film mirror in the outdoors for more than one year, a silver reflective layer and an anti- corrosion layer, which is composed of an acrylic resin, provided on the silver reflective layer were peeled off, resulting in a great degradation of reflectance.
According to a technique disclosed in Patent Literature 3, an acrylic silicone resin, which adheres with a silver reflective layer strongly, composed of an acrylic resin and a silane coupling agent was used as an anti-corrosion layer so as to suppress delaminating. However, when such an acrylic silicone resin was used as an anti-corrosion layer under the conditions being exposed in the sunlight for more than one year, like a film mirror for solar thermal power generation, the silver reflective layer may generate discoloration into purplish red, although the adhesion of the anti-corrosion layer could be maintained.
As a result, no film mirror has been proposed that can be used for solar thermal power generation, has a high adhesion property against stress caused by a cleaning work after a long time exposure in the outdoors and occurs no discoloration.

### Prior Art Literature

### Patent Literature

PATENT LITERATURE 1: JP2009-520174A
PATENT LITERATURE 2: United States Patent No. 7,507,776
PATENT LITERATURE 3: JP2004-203014A

### SUMMARY OF THE INVENTION

### PROBLEM TO BE SOLVED BY THE INVENTION

An object of the present invention is to provide a film mirror that is light-weight and flexible and exhibits high weather resistance such that peeling at an interface between a reflective layer caused by cleaning does not occur even after long time- installation in the outdoors and keeps a good regular reflectance to sunlight, and also to provide a reflecting device for solar thermal power generation using the film mirror.

### MEANS TO SOLVE THE PROBLEM

An object of the present invention can be achieved by the configurations explained below.
An embodiment of the invention is a film mirror in which a reflective layer is provided over a film base. The film mirror includes an anti-corrosion layer provided adjacent to the reflective layer on a light-reflecting side, and a hard coat layer provided on the light-reflecting side of the anti-corrosion layer, in which the anti-corrosion layer is formed by including a silicone-modified resin and containing a silane coupling agent, and the hard coat layer contains a UV absorber.
Preferably, the hard coat layer is provided at an outermost surface on the light-reflecting side.
Preferably, the silicone-modified resin is an acrylic silicone resin.
Preferably, the anti-corrosion layer contains a corrosion preventing agent.
Preferably, the hard coat layer contains an antioxidant.
Preferably, the reflective layer is a silver reflective layer.

Another embodiment of the invention is a reflecting device for solar thermal power generation, which is formed by bonding one of the above film mirrors to a support.

Another embodiment of the invention is a functional film in which a silver layer is provided over a film base. The functional film includes an anti-corrosion layer provided adjacent to the silver layer on a reflecting side and a hard coat layer provided on the reflecting side with respect to the anti-corrosion layer, in which the anti-corrosion layer is formed by including a silicone-modified resin and containing a silane coupling agent, and the hard coat layer contains a UV absorber.

### ADVANTAGEOUS EFFECTS OF THE INVENTION

According to the present invention, a film mirror is provided that does not generate discoloration of a reflective layer even exposed under outdoors environment for a long time and can keep high regular reflectance for a long time because peeling off of an interface between a reflective layer is not prone to occur even when a stress is subjected by a cleaning work or the like. A reflecting device for solar thermal power generation using the film mirror is also provided. In addition, the present invention is applicable to a functional film such as a thermal insulation film having a silver layer for reflecting heat ray as well as a film mirror.

### BRIEF DESCRIPTION OF THE DRAWINGS

FIG 1 is a schematic cross-sectional view of a structure of a film mirror for solar thermal power generation according to an embodiment of the present invention.
FIG 2 is a schematic cross-sectional view of a structure of a film mirror for solar thermal power generation according to an embodiment of the present invention.
FIG 3 is a schematic cross-sectional view of a structure of a film mirror for solar thermal power generation according to an embodiment of the present invention.

### EMBODIMENTS TO CARRY OUT THE INVENTION

As a result of diligent study, the inventors have found that the phenomenon, which a silver reflective layer is discolored into purplish red when an acrylic silicone resin composed of an acrylic resin and a silane coupling agent was used as an anti-corrosion layer, is a typical phenomenon of a film mirror for solar thermal power generation that is exposed in the outdoors for a long time and that the phenomenon occurs when an unreacted silane coupling agent is exposed to UV with the silver reflective layer being adjacent.
Based on the above study, it has been found that a film mirror, whose interface between a silver reflective layer and an anti- corrosion layer is less prone to peeling off, having high adhesion property (adhesiveness) even when a stress is loaded by a cleaning stress after long-time-exposure in the outdoors and exhibiting no discoloration, can be obtained by providing an anti-corrosion layer composed of a silicone-modified resin and a silane coupling agent on/over a silver reflective layer as well as a hard coat layer containing a UV absorber at the outermost surface. The reason is assumed that the dissipation of heat generated by conversion from UV light to heat by the UV absorber proceeds effectively because of a high thermal conductivity of the hard coat layer having high rigidity and thus the UV absorber can effectively convert UV light to heat, so that the UV-degradation of the unreacted silane coupling agent is suppressed. In addition, because the UV absorber can convert UV light to heat effectively, the UV absorber itself lasts long and the UV absorption capacity is maintained stably for a long time.

Hereinafter, film mirrors for solar thermal power generation according to the invention will be described in detail. However it should be noted that the invention is not limited to the embodiments and drawings although the embodiments explained below include various preferable technical limitations to carry out the invention.

### (1) Summary of Structure of Film Mirror for Solar Thermal Power Generation

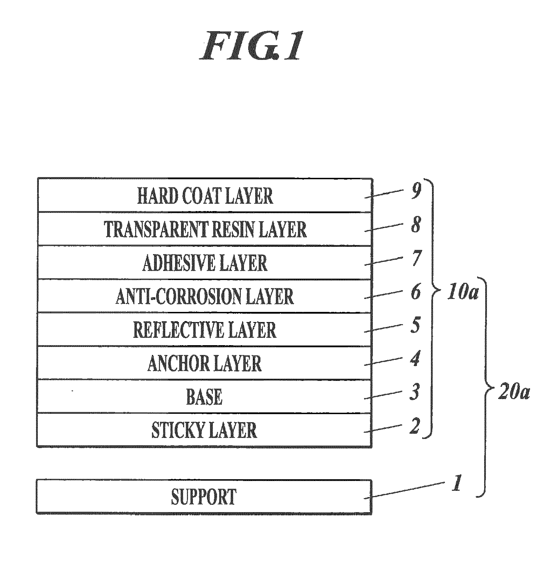

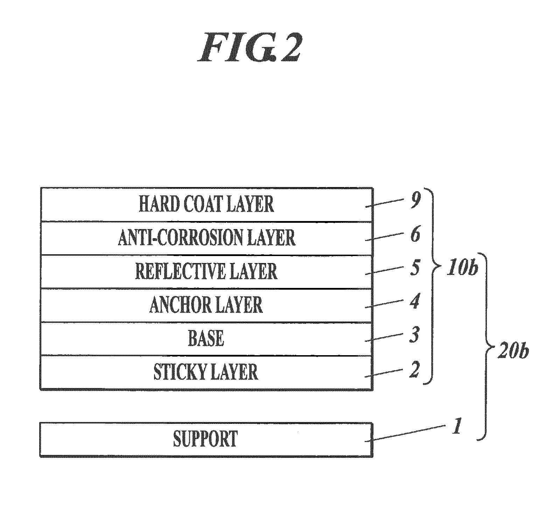

Three types of film mirrors for solar thermal power generation according to the invention will be explained as structural examples with reference to FIGs. 1, 2 and 3.
The film mirrors for solar thermal power generation 10a, 10b and 10c include at least a reflective layer 5, an anti-corrosion layer 6 laminated adjacent to the light-reflecting side of the reflective layer 5, and a hard coat layer 9 laminated at the outermost surface on the light-reflecting side, as structural components, on/over a base (substrate) 3 as a film base having a sticky layer 2 on the opposite side of the light-reflecting side as shown in FIGs. 1, 2 and 3. The anti-corrosion layer 6 is a corrosion-prevention layer which includes at least silicone-modified resin and is formed by containing a silane coupling agent. The hard coat layer 9 contains a UV absorber.
An anchor layer 4 may be provided between the base 3 and the reflective layer 5 as another structural layer of the film mirror (see FIGs. 1 and 2). It is also preferable to provide an adhesive layer 7 and an (optically) transparent resin layer 8 between the anti-corrosion layer 6 and the hard coat layer 9 (see FIG 1).
It is also preferable as another embodiment to bond the anti-corrosion layer 6 and the transparent resin layer 8 to the reflective layer 5 without the adhesive layer 7. When a film mirror is formed by such a structure, the productivity may be increased because the transparent resin layer 8 can be provided by an application method. The present invention can be applicable to a functional film such as a thermal insulation film having a silver layer (reflective layer) for reflecting heat ray as well as a film mirror. In such a case, the silver layer is preferably a thin layer such as a thickness of 20 nm or less.

### (2) Film Base

A resin film or glass film can be used for the film base of the present invention.

### <Resin Film>

Various types of known resin films may be used for the film base (film substrate) for the film mirror or functional film of the invention. The examples includes cellulose ester-based film, polyester-based film, polycarbonate-based film, polyallylate-based film, polysulfone (including polyethersulfone)-based film, polyester films such as polyethylene terephthalate and polyethylene naphthalate, polyethylene film, polypropylene film, cellophane, cellulose diacetate film, cellulose triacetate film, cellulose acetate propionate film, cellulose acetate butyrate film, polyvinylidene chloride film, polyvinyl alcohol film, ethylene vinyl alcohol film, syndiotactic polystyrene-based film, polycarbonate film, norbomene-based resin film, polymethylpentene film, polyether ketone film, polyether ketone imide film, polyamide film, fluorine-containing resin film, nylon film, polymethyl methacrylate film, and acryl film.
Of these, polycarbonate-based film, polyester-based film, norbomene-based resin film, and cellulose ester-based film are preferable. In particular, polyester-based film and cellulose ester-based film are preferably used. The films may be manufactured either by melt casting or solvent casting.
Thickness of the film base is preferably adjusted to an appropriated value, depending on, for example, species of the resin and purposes. For example, the thickness is generally adjusted to the range from 10 to 300 µm, preferably from 20 to 200 µm, and more preferably from 30 to 100 µm.

### <Glass Film>

A glass film may be used for a film base for the film mirror or functional film of the present invention.

The glass film is preferably from a glass roll obtained by the down-draw process. More specifically, the glass film is preferably formed by the down-draw process with the front and back surfaces thereof exposed, then taken up into a roll together with a protective sheet stacked thereon, and unrolled for use as disclosed in JP2010-132347 A (Japanese Laid-Open Patent Publication).

In this configuration, the glass film is formed by the down-draw process with the front and back surfaces thereof exposed, and then taken up into a glass roll together with the protective sheet stacked thereon. Accordingly, there is no need of providing a film forming process for forming a protective sheet such as a polymer layer on the front and back surfaces of the glass film before packaging, and also there is no need of providing a removal process for removing the protective sheet such as a polymer layer from the surfaces of the glass film after unpacking.

Since the process time before the packaging may be shortened by the time previously spent for forming the protective sheet, so that the possibility that the glass film may catch any foreign matter on the front and back surfaces thereof may be minimized, and so that there is no case of residue derived from a protective sheet remained after unpacking. As a consequence, the front and back surfaces of the glass film manufactured by the down-draw process may be kept at a good level of cleanliness. It is also advantageous that the front and back surfaces ascribable to the down-draw process may be kept in a high level of cleanliness without polishing, unlike the glass film formed by the float process which needs post-process polishing.

The exposed front and back surfaces of the glass film are protected by the protective sheet when kept in the form of glass roll. In addition, since the front and back surfaces of the glass film are native surfaces having no protective sheet, such as polymer layer formed thereon, so that the glass film is less likely to stick to the protective sheet in the rolled state. Accordingly, the glass film may be suppressed from being damaged in the rolled state in a reliable manner, and also at unpacking as possible, since the glass film and the protective sheet are kept readily separable.

The glass film may readily be sent to the next process without causing warping even after being kept in a rolled state for a long duration of time. Since the taking-up process can produce a long-sheet glass film, the film may be cut into pieces of arbitrary length to produce a variety of sizes of substrate, and the glass film may be prevented from being wasted.

Thickness of the glass film is preferably in the range from 1.0 to 200 µm, more preferably from 30 µm to 150 µm, and still more preferably from 50 to 120 µm. The glass film having a thickness of 1 µm or larger may endure tension in the process of taking up into the roll so that breakage may be prevented and the glass film having a thickness of 200 µm or smaller may be taken up into the roll easily.

By adjusting the thickness in the above-described ranges, the glass film will have an appropriate level of flexibility. Accordingly, the glass film may be relieved from unnecessarily large stress exerted thereon in the process of taking-up and thereby prevented from being damaged.

In the configuration described in the above, the glass film preferably has an arithmetic average roughness Ra, at the both end faces in the width-wise direction, of 0.1 µm or smaller. The "arithmetic average roughness Ra" herein means a value measured by a method pursuant to JIS B0601:2001.

In such a way, an appropriate level of smoothness may be given to both end faces in the width-wise direction of the glass film. Accordingly, the glass film may be prevented from being finely scratched on both end faces thereof in the process of taking-up into the roll and thereby prevented from being damaged from both end faces. Since glass powder (cullet) possibly generated due to fine scratches on the end faces of the glass film may be reduced, this will be very advantageous in terms of ensuring cleanliness on the front and back surfaces of the glass film. Even when the end faces of the glass film and protective sheet were brought into contact, the end faces of the glass film will not be bitten into the protective sheet nor caught up, successfully keeping a good level of separability between the glass film and the protective sheet.

In the configuration described in the above, both end faces of the glass film are preferably composed of cross section given by laser cutting. The laser cutting herein includes not only laser fusion cutting but also laser cleavage cutting.

### (3) Anchor Layer

The anchor layer is composed of a resin and acts to tightly bond the film base and the reflective layer. Accordingly, it is necessary for the anchor layer to show a bonding property enough to tightly bond the film base and the reflective layer, heat resistance enough to resist heat in the process of forming the reflective layer typically by vacuum deposition and smoothness enough to ensure an excellent reflective performance intrinsic to the reflective layer.
The resin used for the anchor layer is not specifically limited so long as it satisfies the above-described conditions for bonding property, heat resistance and smoothness, and is exemplified by polyester-based resin, acrylic resin, melamine-based resin, epoxy-based resin, polyamide-based resin, vinyl chloride-based resin, vinyl chloride vinyl acetate copolymer-based resin, which may be used independently, or in the form of mixed resin, especially when the film base is a resin film. From the viewpoint of weather resistance, a mixed resin of polyester-based resin and melamine-based resin is preferable, and a thermosetting resin additionally mixed with a curing agent such as an isocyanate is more preferable.
Thickness of the anchor layer is preferably 0.01 to 3 µm, and more preferably 0.1 to 1 µm. When the thickness is adjusted to the above-described ranges, the bonding property is improved, proving a large effect of formation of the anchor layer, surface irregularity of the film base may be concealed, the smoothness is improved, and the reflectance of the reflective layer increases as a consequence. The bonding property is not expectable even when the thickness of the anchor layer is adjusted to exceed 3 µm and may even degrade the smoothness due to non-uniformity in coating.
Available methods of forming the anchor layer include gravure coating, reverse coating, die coating, and any other publicly known methods of coating.

### (4) Reflective Layer

The reflective layer is a layer composed, for example, of metal capable of reflecting sunlight.
Reflectance of the surface of the reflective layer is preferably 80% or larger, and more preferably 90% or larger. The reflective layer is preferably formed using a material containing any of elements selected from the group consisting of Al, Ag, Cr, Cu, Ni, Ti, Mg, Rh, Pt and Au. Among them, the material preferably contains Al or Ag as a major component from the viewpoint of reflectance and corrosion resistance. It is also preferable to form two or more layers of film of these metals. In the present invention, it is particularly preferable to form a silver reflective layer mainly composed of silver.
It is also preferable to provide, over the reflective layer, a layer of metal oxide such as SiO₂ and TiO₂ so as to further improve the reflectance.
Both of wet process and dry process are available as methods of forming the reflective layer used in the present invention (for example, silver reflective layer which is also referred to as silver layer).
The wet process is a general term for plating or a metal complex solution application method by which metal is deposited from solution to form a film. Specific examples include a silver mirror reaction and a silver layer formation by firing of silver complex ink.
On the other hand, the dry process is a general term for vacuum film forming and specific examples include resistance heating vacuum deposition, electron beam heating vacuum deposition, ion plating, ion beam-assisted vacuum deposition and sputtering. Among those, preferably used in the present invention is a vacuum deposition that can be adapted to a roll-to-roll continuous film formation. In short, in the method for producing the film mirror of the present invention, the reflective layer is preferably formed by vacuum deposition of silver.
Thickness of the reflective layer is preferably 10 to 200 nm from the viewpoint of reflectance, and more preferably 30 to 150 nm.

### (5) Anti-corrosion Layer (Corrosion Prevention Layer)

The anti-corrosion layer (corrosion prevention layer) is provided in adjacent to the reflective layer for the purpose of preventing corrosion of a material (silver, for example) of the reflective layer. Here, "corrosion" is defined as a phenomenon such that metal material (silver) is eroded in a chemical or electrochemical manner or degraded in the material performance by an environmental substance surrounding it (see JIS Z0103-2004). The anti-corrosion layer used for the present invention needs to include a silicone-modified resin and to be formed by containing a silane coupling agent. An anti-corrosion layer at least including a silicone-modified resin and being formed by containing a silane coupling agent can keep high film-adhesion capability with the reflective layer for a long period under the outdoors environment.

### (5-1) Silicone-modified Resin

A silicone-modified resin means a resin having a siloxane bonding (-Si-O-)ₙ at the end portion of a main chain, side chain or resin skeleton. Where n is an integer of 1 or larger.
The silicone-modified resin may be formed such that a resin having a polysiloxane structure is bonded by graft-bonding to a resin as a main skeleton, or a silane coupling agent is bonded to a resin as a main skeleton. Other portion than the siloxane bonding of the silicone-modified resin has a resin skeleton such as a cellulose ester, polyester, polycarbonate, polyarylate, polysulfone (including polyethersulfone), polyester such as polyethylene terephthalate or polyethylene naphthalate, cellulose diacetate, cellulose triacetate, cellulose acetate propionate, cellulose acetate butyrate, polyvinylidene chloride, polyvinyl alcohol, ethylene vinyl alcohol, syndiotactic polystyrene, polycarbonate, norbomene-based resin, polymethylpentene, polyether ketone, polyether ketone imide, polyamide, fluororesin, nylon, poly(methyl methacrylate), acrylic resin, polyurethane resin or alkyd resin. Particularly, that having an acrylic resin skeleton or alkyd resin skeleton such as an acrylic silicone or silicone alkyd is preferable and an acrylic silicone having an acrylic resin skeleton is more preferable. Those having an amino group in the acrylic resin skeleton are further preferable.
Examples of a silicone-modified resin, to a resin skeleton of which a polysiloxane structure is graft-bonded, are BECKOLITE M-6652-60 (DIC Corporation), BECKOLITE M-6650-60 (DIC Corporation), Baysilone Resin UD-460M (Bayer), KP-541 (Shin-Etsu Chemical Co., Ltd.), KP-543 (Shin-Etsu Chemical Co., Ltd.), KP-545 (Shin-Etsu Chemical Co., Ltd.), KP-549 (Shin-Etsu Chemical Co., Ltd.), KP-550 (Shin-Etsu Chemical Co., Ltd.) and Metatron (TAIHO CHEMICAL INDUSTRY CO., LTD.).
Examples of an acrylic resin having an amino group in a skeleton are PTC-05 (FUJIKURA KASEI CO., LTD.), PTC-0505 (FUJIKURA KASEI CO., LTD.), PTC-05-B2 (FUJIKURA KASEI CO., LTD.), PTC-05N (FUJIKURA KASEI CO., LTD.), PTC-05N-B2 (FUJIKURA KASEI CO., LTD.), OrigiTug #100 clear (Origin Electric Co. Ltd.), T40-a0.7h (Origin Electric Co. Ltd.), T50-a0.7h (Origin Electric Co. Ltd.) and T40-b1.5h (Origin Electric Co. Ltd.).

### (5-2) Silane Coupling Agent

Examples of the silane coupling agent used for the present invention are, for example, 3-glycidoxypropylmethyl diethoxysilane, 2-(3,4-epoxycyclohexyl)ethyltrimethoxysilane, 2-glycidoxyethoxy trimethoxysilane, 2-glycidoxyethyl triethoxysilane, 3-aminopropyl trimethoxysilane, 3-aminopropyl triethoxysilane, N-2-(aminoethyl)-3-aminopropylmethyl dimethoxysilane, N-2-(aminoethyl)-3-aminopropylmethyl trimethoxysilane, N-2-(aminoethyl)-3-aminopropylmethyl triethoxysilane, 3-triethoxysilyl-N-(1, 3-dimethyl-butylidene)propylamine, N-phenyl-3-aminopropyl trimethoxysilane, N-(vinylbenzyl)-2-aminoethyl-3-aminopropyl trimethoxysilane hydrochloride, vinyltrimethoxysilane, vinyltriethoxysilane, 3-methacryloxypropylmethyl dimethoxysilane, 3-acryloxypropyl trimethoxysilane, 3-ureidpropyl triethoxysilane, 3-mercaptopropylmethyl dimethoxysilane, 3-mercaptopropylmethyl trimethoxysilane, and 3-isocyanatepropyl triethoxysilane. Even in a case where a silane coupling agent was bonded to a main skeleton resin, an unreacted silane coupling agent or reaction compounds of the silane coupling agents may be remained in the anti-corrosion layer. According to the present invention, it becomes possible to prevent problems caused by the unreacted silane coupling agent or reaction compounds of the silane coupling agents with UV ray, so that the anti-corrosion layer may be used successively without much concern of the added amount of the silane coupling agent.

### (5-3) Corrosion Preventing Agent

The anti-corrosion layer preferably contains a corrosion preventing agent.
A corrosion preventing agent used for the anti-corrosion layer may be selected from the group of corrosion preventing agents such as benztriazole-based compounds, imidazole-based compounds, sulfur-based compounds, tetrazaindene-based compounds, and thiadiazole-based compounds. Two or more of these selectable compounds may be used in combination.
A general formula of the selectable corrosion preventing agent is shown below.

### (5-3-1) Benztriazole-based Compound

A benztriazole-based compound is represented by the following general formula (1).

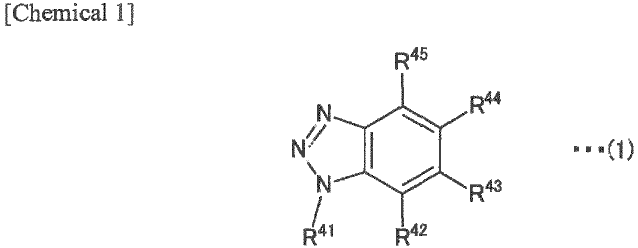

In the formula, each of R⁴¹ to R⁴⁵ represents a hydrogen atom or a substituent. Examples of the substituents are a halogen atom (e.g. fluorine or chlorine), alkyl group (e.g. methyl group, ethyl group, isopropyl group, hydroxyethyl group, methoxymethyl group, trifluoromethyl group or t-butyl group), cycloalkyl group (e.g. cyclopentyl group or cyclohexyl group), aralkyl group (e.g. benzyl group or 2-phenetyl group), aryl group (e.g. phenyl group, naphtyl group, p-tolyl group or p-chlorophenyl group), alkoxy group (e.g. methoxy group, ethoxy group, isopropoxy group or butoxy group), aryloxy group (e.g. phenoxy group), cyano group, acylamino group (e.g. acetylamino group or propionyl group), alkylthio group (e.g. methylthio group, ethylthio group or butylthio group), arylthio group (e.g. phenylthio group), sulfonylamino group (e.g. methane sulfonylamino group or benzene sulfonylamino group), ureido group (e.g. 3-methyl ureido group, 3,3-dimethyl ureido group or 1,3-dimethyl ureido group), sulfamoylamino group (e.g. dimethyl sulfamoylamino group), carbamoyl group (e.g. methyl carbamoyl group, ethyl carbamoyl group or dimethyl carbamoyl group), sulfamoyl group (e.g. ethyl sulfamoyl group or dimethyl sulfamoyl group), alkoxycarbonyl group (e.g. methoxycarbonyl group or ethoxycarbonyl group), aryloxycarbonyl group (e.g. phenoxycarbonyl group), sulfonyl group (e.g. methane sulfonyl group, butane sulfonyl group or phenyl sulfonyl group), acyl group (e.g. acetyl group, propanoyl group or butyloyl group), amino group (e.g. methylamino group, ethylamino group or dimethylamino group), cyano group, hydroxyl group, nitro group, nitroso group, aminoxide group (e.g. pyridine-oxide group), imide group (e.g. phthalimide group), disulfide group (e.g. benzene disulfide group or benzothiazoryl-2-disulfide group), carboxyl group, sulfo group and hetero-ring group (e.g. pyrrole group, pyrrolidil group, pyrrazolyl group, imidazolyl group, pyridyl group, benzimidazolyl group, benzthiazolyl group or benzoxazolyl group). These substituents may be further substituted.
Examples of benzotriazole-based compounds are 2-(2'-hydroxy-5-methylphenyl)benzotriazole, 2-(2'-hydroxy-3'5'-di-t-butylphenyl)benzotriazole, and 2-(2'-hydroxy-3'-t-butyl-5'-methylphenyl)benzotriazole.
Such a benzotriazole-based compound is available, for example, as a trade name for TINUVIN P, TINUVIN 234 or TINUVIN 328 from Ciba Japan Ltd.

### (5-3-2) Imidazole-based Compound

An imidazole-based compound is represented by the following general formula (2).

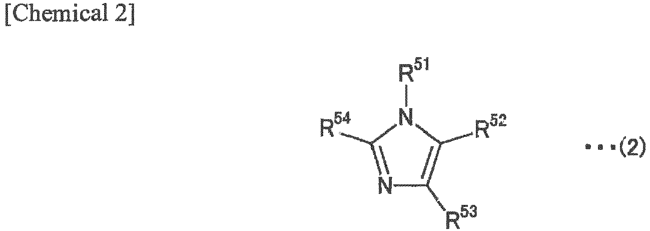

In the formula, each of R⁵¹ to R⁵⁴ represents a substituent. The same substituents may be assigned for R⁵¹ to R⁵⁴ as the substituents for R⁴¹ to R⁴⁵ of the general formula (1). Preferably a hydrogen atom is selected for R⁵¹.
Examples of the imidazole-based compound are 2-methylimidazole, 2-mercaptoimidazole, 5,6-dimethylbenzimidazole and 2-mercaptobenzimidazole.
The imidazole-based compounds above mentioned are available as the same trade names as the names of the compounds themselves from Sigma-Aldrich Co. LLC.

### (5-3-3) Sulfur-based Compound

A sulfur-based compound is represented by the following general formula (3).

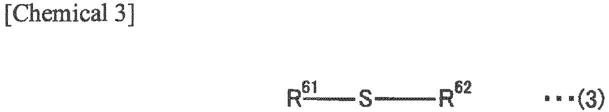

In the formula, each of R⁶¹ and R⁶² represents a substituent. The same substituents may be assigned as the substituents for R⁴¹ to R⁴⁵ of the general formula (1).
Examples of the sulfur-based compound are, for example, butanediol bisthioglycolate, trimethylolpropane tristhiopropionate, triethyleneglycol dimercaptan, dilauryl 3,3-thiodipropionate, dimylistyl 3,3'-thiodipropionate, distearyl 3,3-thiodipropionate, laurylstearyl 3,3-thiodipropionate, pentaerythritol-tetrakis(β-lauryl-thio-propionate), and 3,9-bis(2-dodecylthioethyl)-2,4,8,10-tetraoxaspiro[5,5] undecane.
Such sulfur-based compounds above mentioned are available as trade names for BDTG, TMTG, PETG, TMTP and PETP from Yodo Kagaku Co., Ltd.

### (5-3-4) Tetrazaindene-based Compound

The tetrazaindene-based compound is represented by the following general formula (4).

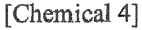

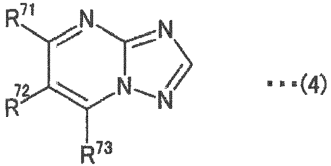

[0042] In the formula, each of R⁷¹ to R⁷³ represents a substituent. The same substituents may be assigned as the substituents for R⁴¹ to R⁴⁵ of the general formula (1).
Examples of the tetrazaindene-based compound are, for example, 7-hydroxy-5-methyl[1,2,4]triazolo[1,5-a]pyrimidine, 5,6-dimethyl[1,2,4]triazolo[1,5-a]pyrimidine-7-ol, and 5-methyl-2-(methylthio)-1,3,4-triazaindolizine-7-ol.
The tetrazaindene-based compounds above mentioned are available as the same trade names as the names of the compounds themselves from Sigma-Aldrich Co. LLC.

### (5-3-5) Thiadiazole-based Compound

The thiadiazole-based compound is represented by the following general formula (5).

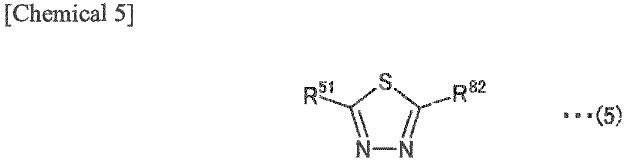

[0044] In the formula, each of R⁸¹ and R⁸² represents a substituent. The same substituents may be assigned as the substituents for R⁴¹ to R⁴⁵ of the general formula (1).
Examples of the thiadiazole-based compound are, for example, 1,3,4-thiadiazole-2,5-dithiol, 5-(ethylthio)-1,3,4-thiadiazole-2-thiol, and 5,5'-(ethylenedithio)bis(1,3,4-thiadiazole-2-thiol).
The thiadiazole-based compounds above mentioned are available as the same trade names as the names of the compounds themselves from Sigma-Aldrich Co. LLC.

### (6) [Hard Coat Layer]

The hard coat layer is provided on the light-reflecting side of the anti-corrosion layer of the film mirror, and preferably provided on the outermost surface. In a film mirror 10a shown in FIG.1, for example, a hard coat layer 9 is laminated on an acrylic resin layer 8 and provided at the outermost surface. In a film mirror 10b shown in FIG 2, a hard coat layer 9 is laminated on an anti- corrosion layer 6 and provided at the outermost surface. The hard coat layer is provided so as to hold a UV absorber so as to function efficiently for a long time as well as to prevent the surface of the film mirror being scratched or stained.
The hard coat layer is preferably formed by using, for example, acrylic resin, urethane-based resin, melamine-based resin, epoxy-based resin, organosilicate compound or silicone-based resin by UV curing or heat curing.
According to the present invention, the hard coat layer has to contain a UV absorber of an organic material or inorganic material. Also the hard coat layer may contain a photo-sensitizer, photo- polymerization initiator, thermal polymerization initiator or modifier.

### (6-1) UV-curing Hard Coat

A UV-curing hard coat is a hard coat a resin of which is cured by a UV irradiation step. The UV irradiation step means to irradiate energy (UV ray) of 80 mj or more using a high pressure mercury lamp or the like. The UV-curable resin is exemplified by (meth)acrylate-based resin such as those containing trimethylolpropane tri(meth)acrylate, trimethylolpropane tris(hydroxyethyl (meth)acrylate), tris(2-hydroxyethyl)isocyanurate tri(meth)acrylate, pentaerythritol tri(meth)acrylate, pentaerythritol tetra(meth)acrylate, dipentaerythritol hexa(meth)acrylate, or multifunctional urethanized (meth)acrylate as a major component. The multifunctional urethanized (meth)acrylate herein means a compound having in the molecule thereof a urethane bond and at least two (meth)acryloyl groups, obtained by an addition reaction to allow, for example, polyisocyanate having at least two ixocyanatato groups (-NCO) such as isophorone diisocyanate and hexamethylene diisocyanate, to react with a compound having in the molecule thereof one hydroxy group and at least one (meth)acryloyl group such as trimethylolpropane di(meth)acrylate and pentaerythritol tri(meth)acrylate. These UV-curable resins may be used independently or in the form of mixture of two or more species. Alternatively, the multifunctional urethanized (meth)acrylate may be used in combination with the above-described multifunctional (meth)acrylate having no urethane bond.

The UV-curable resin preferably used herein may be selected from those commercially available. Specific examples of commercially available products of the UV-curable resin include Kayarad DPHA (from Nippon Kayaku Co. Ltd.), Kayarad DPCA-20 (from Nippon Kayaku Co. Ltd.), Kayarad DPCA-30 (from Nippon Kayaku Co. Ltd.), Kayarad DPCA-60 (from Nippon Kayaku Co. Ltd.), Kayarad DPCA-120 (from Nippon Kayaku Co. Ltd.), Kayarad D-310 (from Nippon Kayaku Co. Ltd.), Kayarad D-330 (from Nippon Kayaku Co. Ltd.), Kayarad PET-30 (from Nippon Kayaku Co. Ltd.), Kayarad GPO-303 (from Nippon Kayaku Co. Ltd.), Kayarad TMPTA (from Nippon Kayaku Co. Ltd.), Kayarad THE-330 (from Nippon Kayaku Co. Ltd.), Kayarad TPA-330 (from Nippon Kayaku Co. Ltd.), Aronix M-315 (from Toagosei Co. Ltd.), and Aronix M-325 (from Toagosei Co. Ltd.). The above-described UV-curable resin is generally used in the form of mixture with a photo-polymerization initiator. Examples of the photo- polymerization initiator preferably used herein are commercially available products such as Irgacure 907 (from Chiba Specialty Chemicals Inc.), Irgacure 184 (from Ciba Specialty Chemicals Inc.), and Lucirin TPO (from BASF A.G).

### (6-2) Thermosetting (heat-curing) Hard Coat

The thermosetting hard coat is a hard coat a resin of which is cured by a heating step and can be formed by a method including a heating step so as to cure an acrylic resin, urethane-based resin, melamine-based resin, epoxy-based resin, organosilicate compound, silicone-based resin, or the like. The heating step of resin means a step to cure an applied binder resin by a treatment in an atmosphere at 40°C or higher for 1 minute or more. To form a thermosetting resin layer with a sufficient crosslink density, it is necessary to perform a treatment in an atmosphere at 40 to 150°C for 1 minute to several days. The layer is preferably allowed to stand in an atmosphere at 60°C to 100°C for 30 minutes to 2 days so that it can have a sufficient hardness.
Thermosetting resins that may be used include a silicone-based resin or silicone-modified resin, acrylic-based resin, phenol-based resin, epoxy-based resin, polyester-based resin, polyurethane-based resin, melamine-based resin, and urea-based resin. According to the present invention, a silicone-based resin or silicone-modified resin is preferably used

A precursor compound used to form a silicone-based resin is represented by the general formula RₘSi(OR')ₙ where R and R' each represents an alkyl group of 1 to 10 carbon atoms, and m and n each represents an integer satisfying the relation m+n=4.
Examples of such precursor compounds include tetramethoxysilane, tetraethoxysilane, tetra-iso-propoxysilane, tetra-n-propoxysilane, tetra-n-butoxysilane, tetra-sec-butoxysilane, tetra-tert-butoxysilane, tetrapentaethoxysilane, tetrapenta-iso-propoxysilane, tetrapenta-n-propoxysilane, tetrapenta-n-butoxysilane, tetrapenta-sec-butoxysilane, tetrapenta-tert-butoxysilane, methyltriethoxysilane, methyltripropoxysilane, methyltributoxysilane, dimethyldimethoxysilane, dimethyldiethoxysilane, dimethylethoxysilane, dimethylmethoxysilane, dimethylpropoxysilane, dimethylbutoxysilane, dimethyldimethoxysilane, dimethyldiethoxysilane, hexyltrimethoxysilane, and the like. A silane coupling agent such as γ-(2-aminoethyl)aminopropyltrimethoxysilane, γ-(2-aminoethyl)aminopropylmethyldimethoxysilane, β-(3,4-epoxycyclohexyl)ethyltrimethoxysilane, N-β-(N-aminobenzylaminoethyl)-γ-aminopropylmethoxysilane hydrochloride, γ-glycidoxypropyltrimethoxysilane, aminosilane, methylmethoxysilane, vinyltriacetoxysilane, γ-mercaptopropyltrimethoxysilane, γ-chloropropyltrimethoxysilane, hexamethyldisilazane, vinyltris(β-methoxyethoxy)silane, octadecyldimethyl[3-(trimethoxysilyl)propyl]ammonium chloride, methyltrichlorosilane or dimethyldichlorosilane, or an ionizing radiation-curable siloxane compound may also be used. Specifically, the ionizing radiation-curable siloxane compound may be an organosilicon compound with a molecular weight of 5,000 or less having two or more functional groups, such as polymerizable double bond-containing groups, capable of undergoing a crosslinking reaction upon irradiation of ionizing radiation. More specifically, the ionizing radiation-curable siloxane compound may be polysiloxane terminated at one end by a vinyl functional group, polysiloxane terminated at both ends by vinyl functional groups, or vinyl functional polysiloxane obtained by reaction between these compounds. The composition forms three-dimensionally cross-linkage by dehydration condensation of silanol groups to form a high-hardness coating.

The silicone-modified resin used for the hard coat layer 9 of the invention may be a graft copolymer having a silicone side chain. Such a resin is preferably an acrylic graft copolymer having a silicone side chain. A silicone-based graft copolymer can be produced by radical polymerization of an acrylic modified silicone high-molecular-weight monomer and a radically-polymerizable monomer and the graft copolymer is exemplified by the acrylic modified silicone that is produced by condensation of a silicone represented by general formula (6) below and an acrylic compound represented by general formula (7) below.

In the formula (6), R⁶ and R⁷ each represent a monovalent aliphatic hydrocarbon group of 1 to 10 carbon atoms, a phenyl group, or a monovalent halogenated hydrocarbon group, and q is a positive number of 1 or more.

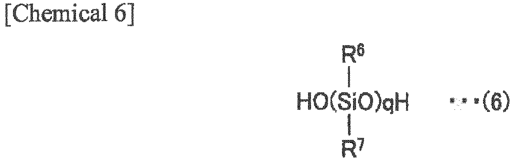

In the formula (7), R⁸ represents a hydrogen atom or a methyl group and R⁹ represents a methyl group, an ethyl group or a phenyl group. Both of R⁹ may be the same or different and Z represents a chlorine atom, a methoxy group or an ethoxy group.

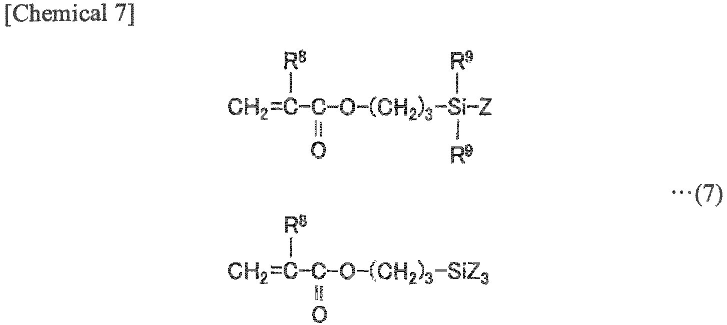

The silicone represented by general formula (6) is commercially available, and commercially available products suitable for intended purpose can be used. In general formula (6), R⁶ and R⁷ each represent a monovalent aliphatic hydrocarbon group of 1 to 10 carbon atoms, a phenyl group or a monovalent halogenated hydrocarbon group. For example, the monovalent aliphatic hydrocarbon group of 1 to 10 carbon atoms may be methyl, ethyl, acyl or the like and the monovalent halogenated hydrocarbon group may be 3,3,3-trifluoropropyl group, 4,4,4-trifluoro-3,3-diffuorobutyl group, 2-chloroethyl or the like. In particular, R⁶ and R⁷ are each preferably methyl group.
In general formula (6), q is a positive number of 1 or more. In general, an oily product tends to be obtained by copolymerization of a radically-polymerizable monomer and the acrylic modified silicone derived from the silicone with a high molecular weight such that the number of q is 100 or more. And various types of products such as oily, gelatinous, and solid products can be obtained, depending on the type of the monomers used, by copolymerization of a radically-polymerizable monomer and the acrylic modified silicone derived from the silicone with a low molecular weight such that the number of q is 100 or less.
Examples of the acryl-silane compound represented by general formula (7) include γ-methacryloxypropyldimethylchlorosilane, γ-methacryloxypropyldimethylethoxysilane, γ-methacryloxypropyldiphenylchlorosilane, γ-acryloxypropyldimethylchlorosilane, γ-methacryloxypropyltriethoxysilane, γ-methacryloxypropyltrichlorosilane and the like. These acryl-silane compounds can be easily obtained by reaction of a silicon compound with a compound having an aliphatic multiple bond under the presence of platinic chloride according to a method as disclosed in JP33-9969B, for example.
The radical polymerization of the acrylic modified silicone and the radically-polymerizable monomer can be performed using a conventionally known method, such as an irradiation method or a method using a radial polymerization initiator. The copolymerization may also be performed by an ultraviolet irradiation method using a known sensitizer as a radial polymerization initiator. The copolymerization may also be performed by an electron beam irradiation method, and in this case, there is no need to use a radial polymerization initiator. The silicone copolymer obtained as described above is a comb-shaped graft copolymer including a radically-polymerizable monomer-derived backbone and a silicone branch.
Examples of commercially available silicone copolymers include Cymac US-150, US-270, US-350, US-450 and Rezeda GP-700 (all manufactured by Toagosei Co., Ltd.), and SARCoat NP-730 and SARCoat NP-720 (all manufactured by DOKEN CO., LTD.).

### (6-3) Silica Fine Particles

Silica fine particles may be added to the curable resin composition for forming a hard coat layer so as to obtain a hard coat layer having a sufficient level of hardness and being capable of sufficiently suppressing curling due to curing shrinkage.
The silica fine particle preferably used in this case is exemplified by powdery silica and colloidal silica, with an average particle size of 0.01 to 20 µm. The silica fine particle is preferably not affective to transparency of the hard coat film, and therefore preferably has a primary particle size of 10 to 350 nm, and more preferably 10 to 50 nm. The above-described average particle size of silica fine particle is measurable, for example, by observation under a transmission electron microscope, and the primary particle size of silica particle is measurable, for example, by making a dispersion solution of the particle with a solvent such as isopropanol and using a Coulter particle size distribution analysis, laser diffraction and scattering method or dynamic light scattering method. Among them, the Coulter particle size distribution analysis is generally adopted.
While geometry of the silica fine particle may be spherical, hollow, porous, rod-like, plate-like, fibrous, or undefined, it is preferably spherical in view of thoroughly dispersing the particle in the curable resin without causing coagulation of particle. From the viewpoint of ensuring hardness and planarity of the hard coat layer, the specific surface area of the silica fine particle preferably falls in the range from 0.1 to 3000 m²/g, more preferably 1 m²/g or larger and particularly 10 m /g or larger and 1500 m²/g or smaller.
The silica fine particle is also preferably selectable from those commercially available. Examples of marketed product of colloidal silica include methanol silica sol (Nissan Chemical Industries, Ltd.), IPA-ST (Nissan Chemical Industries, Ltd.), MEK-ST (Nissan Chemical Industries, Ltd.), NBA-ST (Nissan Chemical Industries, Ltd.), XBA-ST (Nissan Chemical Industries, Ltd.), DMAC-ST (Nissan Chemical Industries, Ltd.), ST-UP (Nissan Chemical Industries, Ltd.), ST-OUP (Nissan Chemical Industries, Ltd.), ST-20 (Nissan Chemical Industries, Ltd.), ST-40 (Nissan Chemical Industries, Ltd.), ST-C (Nissan Chemical Industries, Ltd.), ST-N (Nissan Chemical Industries, Ltd.), ST-O (Nissan Chemical Industries, Ltd.), ST-50 (Nissan Chemical Industries, Ltd.), and ST-OL (Nissan Chemical Industries, Ltd.).
Examples of marketed product of powder silica include Aerosil 130 (Nippon Aerosil Co. Ltd.), Aerosil 300 (Nippon Aerosil Co. Ltd.), Aerosil 380 (Nippon Aerosil Co. Ltd.), Aerosil TT600 (Nippon Aerosil Co. Ltd.), Aerosil OX50 (Nippon Aerosil Co. Ltd.), Sildex H31 (Asahi Glass Co. Ltd.), Sildex H32 (Asahi Glass Co. Ltd.), Sildex H51 (Asahi Glass Co. Ltd.), Sildex H52 (Asahi Glass Co. Ltd.), Sildex H121 (Asahi Glass Co. Ltd.), Sildex H122 (Asahi Glass Co. Ltd.), E220A (Nippon Silica Industrial Ltd.), E220 (Nippon Silica Industrial Ltd.), Sylysia 470 (Fuji Silysia Chemical Ltd.), and SG flake (Nippon Sheet Glass Co. Ltd.).

### (6-4) Leveling Agent

A leveling agent may be preferably added to the curable resin composition used for forming the hard coat layer in order to ensure a good surface smoothness of the resultant hard coat layer.
A leveling agent is a chemical agent capable of reducing surface tension of a coating material when added thereto, and of improving surface smoothness of a paint film to be obtained.
Substances generally used as the leveling agent include polyacrylate-based polymer such as polyalkyl acrylate, polyvinyl ether-based polymer such as polyalkyl vinyl ether, and silicone-based polymer such as dimethylpolysiloxane, methylphenylpolysiloxane, and organic modified polysiloxane introduced with polyether, polyester, aralkyl and so forth. The most preferable leveling agent for the present invention is a sort of polymer additionally containing fluorine atoms. The fluorine atom-containing leveling agent may be obtained typically by allowing a fluorine-containing monomer to co-polymerize.
Specific products on the market include Surflon "S-381", "S-382", "SC-101", "SC-102", "SC-103", "SC-104" (all from Asahi Glass Co. Ltd.), Fluorad "FC-430", "FC-431", "FC-173" (all from Fluorochemicals-Sumitomo 3M Ltd.), Eftop "EF352", "EF301", "EF303" (all from Shin-Akita Kasei Co. Ltd.), Schwego Fluor "8035", "8036" (both from Schwegmann), "BM1000", "BM1100" (both from BM Chemie), Megafac "F-171", "F-470", "RS-75", "RS-72-K" (all from DIC Corporation), BYK340 (BYK Chemie Japan), and "ZX-049", "ZX-001", "ZX-017" (all from Fuji Kasei Kogyo Co. Ltd.).

### (6-5) UV Absorber

The curable resin composition used for forming the hard coat layer preferably contains a UV absorber for the purpose of improving weather resistance of the resultant hard coat layer and resin layers lower than the hard coat layer. The resultant hard coat layer preferably contains a UV absorber composed of an organic compound or a UV absorber composed of an inorganic compound, or the both. The organic compound, if chosen, is preferably a triazine-based UV absorber.

### (6-5-1) Inorganic UV Absorber

The inorganic UV absorber is principally a metal oxide-based pigment compound having a function that, when it is dispersed in an acrylic resin so as to adjust the concentration to 20% by mass or more and a film of 6 µm thick is formed, a light transmittance of the film in the UV-B region (290-320 nm) becomes 10% or less. It is particularly preferable to select the inorganic UV absorber for the present invention from titanium oxide, zinc oxide, iron oxide, cerium oxide or mixtures of them.
From the viewpoint of improving the transparency of the layer containing the inorganic UV absorber, the inorganic UV absorber is preferably selected from those having an average basic particle size of 5 nm to 500 nm and particularly from those having an average particle size of 10 nm to 100 nm, and a maximum particle size in the particle size distribution of 150 nm or below. This sort of coated and non-coated metal oxide pigments are detailed in EP-A-0 518 773 (EP patent).
In the present invention, for the purpose of preventing oxidation degradation of the adjacent resin due to photocatalytic action of the inorganic oxide, an average particle size of the fine particles the surface of which is coated by the inorganic UV absorber may have a size of 10 nm or larger and 100 nm or smaller. The surface coating is more preferable also because it can improve dispersibility of the inorganic UV absorber particles. The surface-coated inorganic UV absorber herein means an inorganic UV absorber treated on the surface thereof with a compound selected from amino acid, beeswax, fatty acid, aliphatic alcohol, anionic surfactant, lecithin, sodium salt, potassium salt, zinc salt, iron salt or aluminum salt of fatty acid, metal alkoxide (of titanium or aluminum), polyethylene, silicone, protein (collagen, elastin), alkanolamine, silicon oxide, metal oxide and sodium hexametaphosphate, by any one of or combination of two or more means selected from chemical, electronic, mechanochemical and mechanical means.
Amount of the inorganic UV absorber, when used alone, is adjusted to 1 to 30% by mass of the total mass of the UV absorbing layer (hard coat layer 9), preferably to 5 to 25% by mass, and more preferably 15 to 20% by mass. The content exceeding 30% by mass will degrade the adhesiveness and the content less than 1% by mass will cause small improvement of weather resistance.
Amount of the inorganic UV absorber, when combined with an organic UV absorber described later, is adjusted to 3 to 20% by mass of the total mass of the UV absorbing layer (hard coat layer 9), preferable to 5 to 10% by mass, whereas amount of use of the organic UV absorber is 0.1 to 10% by mass, and preferably 0.5 to 5% by mass. By using the inorganic UV absorber and the organic UV absorber in combination within the above-described ranges of content, the hard coat layer will possess high transparency and good weather resistance.

### (6-5-2) Low-molecular-weight Triazine-Based UV Absorber

Low-molecular-weight triazine-based UV absorber preferably used in the present invention is represented by the general formula (8) below.

Q¹-Q²-OH (8)

In the formula (8), Q¹ represents a 1,3,5-triazine ring and Q² represents an aromatic ring.
The compound represented by the general formula (8) is more preferably represented by the general formula (9) below.

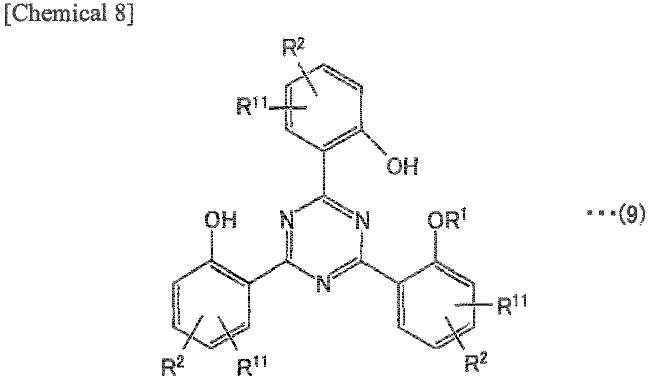

In the formula (9) above, R¹ represents a C₁₋₁₈ alkyl group; C₅₋₁₂ cycloalkyl group; C₃₋₁₈ alkenyl group; phenyl group; C₁₋₁₈ alkyl group substituted by a phenyl group, hydroxy group, C₁₋₁₈ alkoxy group, C₅₋₁₂ cycloalkoxy group, C₃₋₁₈ alkenyloxy group, halogen atom, -COOH, -COOR⁴, -O-CO-R⁵, -O-CO-O-R⁶, -CO-NH₂, -CO-NHR⁷, -CO-N(R⁷)(R⁸), -CN, -NH₂, -NHR⁷, -N(R⁷)(R⁸), -NH-CO-R⁵, phenoxy group, phenoxy group substituted by a C₁₋₁₈ alkyl group, phenyl-C₁₋₄ alkoxy group, C₆₋₁₅ bicycloalkoxy group, C₆₋₁₅ bicycloalkylalkoxy group, C₆₋₁₅ bicycloalkenylalkoxy group, or C₆₋₁₅ tricycloalkoxy group; C₅₋₁₂ cycloalkyl group substituted by a hydroxy group, C₁₋₄ alkyl group, C₂₋₆ alkenyl group or -O-CO-R⁵; glycidyl group; -CO-R⁹ or -SO₂-R¹⁰; or R represents a C₃₋₅₀ alkyl group discontinued by one or more oxygen atoms and/or substituted by a hydroxy group, phenoxy group or C₇₋₁₈ alkylphenoxy group; or R¹ represents any one of -A; -CH₂-CH(XA)-CH₂-O-R¹²; -CR¹³R'¹³-(CH₂)ₘ-X-A; -CH₂-CH(OA)-R¹⁴; -CH₂-CH(OH)-CH₂-XA; 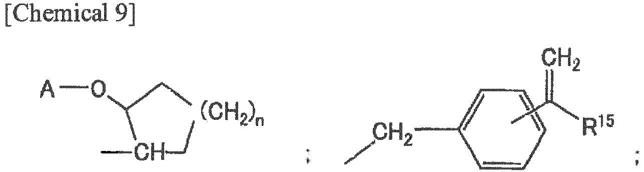 -CR¹⁵R'¹⁵-C(=CH₂)-R"¹⁵; -CR¹³R'¹³-(CH₂)ₘ-CO-X-A;
-CR¹³R'¹³-(CH₂)ₘ-CO-O-CR¹⁵R'¹⁵-C(=CH₂)-R"¹⁵ and -CO-O-CR¹⁵R'¹⁵-C(=CH₂)-R"¹⁵ (in the formulae, A represents -CO-CR¹⁶=CH-R¹⁷).
Each R² independently represents a C₆₋₁₈ alkyl group; C₂₋₆ alkenyl group; phenyl group; C₇₋₁₁ phenylalkyl group; -COOR⁴; -CN; -NH-CO-R⁵; halogen atom; trifluoromethyl group; or -O-R³.
R³ is the same definition as R¹; R⁴ represents a C₁₋₁₈ alkyl group; C₃₋₁ alkenyl group; phenyl group; C₇₋₁₁ phenylalkyl group; C₅₋₁₂ cycloalkyl group; or R⁴ represents a C₃₋₅₀ alkyl group discontinued by one or more -O-, -NH-, -NR⁷-, and -S-, and may be substituted by OH, phenoxy group or C₇₋₁₈ alkylphenoxy group; R⁵ represents H; C₁₋₁₈ alkyl group; C₂₋₁₈ alkenyl group; C₅₋₁₂ cycloalkyl group; phenyl group; C₇₋₁₁ phenylalkyl group; C₆₋₁₅ bicycloalkyl group; C₆₋₁₅ bicycloalkenyl group; C₆₋₁₅ tricycloalkyl group; R represents H; C₁₋₁₈ alkyl group; C₃₋₁₈ alkenyl group; phenyl group; C₇₋₁₁ phenylalkyl group; C₅₋₁₂ cycloalkyl group; each of R⁷ and R⁸ independently represents a C₁₋₁₂ alkyl group; C₃₋₁₂ alkoxyalkyl group; C₄₋₁₆ dialkylaminoalkyl group; or C₅₋₁₂ cycloalkyl group; or both of R⁷ and R⁸ represent C₃₋₉ alkylene group, C₃₋₉ oxaalkylene group or C₃₋₉ azaalkylene group; R⁹ represents a C₁₋₁₈ alkyl group; C₂₋₁₈ alkenyl group; phenyl group; C₅₋₁₂ cycloalkyl group; C₇₋₁₁ phenyl alkyl group; C₆₋₁₅ bicycloalkyl group; C₆₋₁₅ bicycloalkylalkyl group, C₆₋₁₅ bicycloalkenyl group; or C₆₋₁₅ tricycloalkyl group; R¹⁰ represents a C₁₋₁₂ alkyl group; phenyl group; naphthyl group; or C₇₋₁₄ alkylphenyl group; each R¹¹ independently represents H; C₁₋₁₈ alkyl group; C₃₋₆ alkenyl group; phenyl group; C₇₋₁₁ phenylalkyl group; halogen atom; C₁₋₁₈ alkoxy group; R¹² represents a C₁₋₁₈ alkyl group; C₃₋₁₈ alkenyl group; phenyl group; C₁₋₈ alkyl group, C₁₋₈ alkoxy group, C₃₋₈ alkenoxy group, halogen atom or phenyl group substituted once to three times by trifluoromethyl groups; or C₇₋₁₁ phenylalkyl group; C₅₋₁₂ cycloalkyl group; C₆₋₁₅ tricycloalkyl group; C₆₋₁₅ bicycloalkyl group; C₆₋₁₅ bicycloalkylalkyl group; C₆₋₁₅ bicycloalkenylalkyl group; -CO-R⁵; or R¹² represents a C₃₋₅₀ alkyl group discontinued by one or more -O-, -NH-, -NR⁷-, and -S-, and may be substituted by OH, phenoxy group or C₇₋₁₈ alkylphenoxy group; each of R¹³ and R'¹³ independently represents H; C₁₋₁₈ alkyl group; phenyl group; R¹⁴ represents a C₁₋₁₈ alkyl group; C₃₋₁₂ alkoxyalkyl group; phenyl group; phenyl-C₁₋₄ alkyl group; each of R¹⁵, R'¹⁵ and R"¹⁵ independently represents H or CH₃; R¹⁶ represents H; -CH₂-COO-R⁴; C₁₋₄ alkyl group; or CN; R¹⁷ represents H; -COOR⁴; C₁₋₁₇ alkyl group; or phenyl group; X represents -NH-; -NR⁷-; -O-; -NH-(CH₂)ₚ-NH-; or -O-(CH₂)_{q}-NH-; and numeral m represents 0 to 19; numeral n represents 1 to 8; numeral p represents 0 to 4; and numeral q represents 2 to 4; where in the general formula (9), at least one of R¹, R² and R¹¹ contains two or more carbon atoms.

### (6-5-3) Low-molecular-weight Benzophenone-based UV Absorber

Benzophenone-based ultraviolet ray is represented by the general formula (10) below.

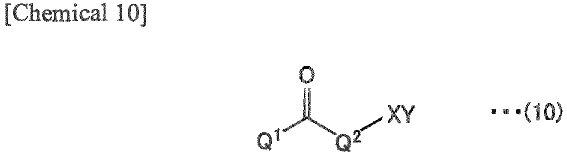

In the formula (10) above, Q¹ and Q² each independently represents an aromatic ring. X represents a substituent, and Y represents an oxygen atom, a sulfur atom, or a nitrogen atom. XY may be a hydrogen atom.
Examples of benzophenone-based UV absorbers include 2,4-dihydroxybenzophenone, 2-hydroxy-4-methoxybenzophenone, 2-hydroxy-4-n-octoxybenzophenone, 2-hydroxy-4-dodecyloxybenzophenone, 2-hydroxy-4-octadecyloxybenzophenone, 2,2'-dihydroxy-4-methoxybenzophenone, 2,2'-dihydroxy-4,4'-dimethoxybenzophenone, and 2,2',4,4'-tetrahydroxybenzophenone.

### (6-5-4) Low-molecular-weight Benzotriazole-based UV Absorber

Benzotriazole-based UV absorber is represented by the general formula (11) below.

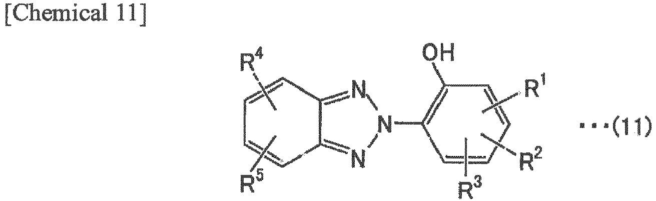

In the formula (11) above, R¹, R², R³, R⁴, and R⁵ each independently represent a monovalent organic group and at least one of R¹, R², and R³ represents an unsubstituted straight or branched chain alkyl group with a total carbon number of 10 to 20.
Example of benzotriazole-based ultraviolet absorbers include 2-(2'-hydroxy-5-methylphenyl)benzotriazole, 2-(2'-hydroxy-3',5'-di-t-butylphenyl)benzotriazole, 2-(2'-hydroxy-3'-t-butyl-5'-methylphenyl)benzotriazole, 2-(2'-hydroxy-5'-methylphenyl)benzotriazole, 2-(2'-hydroxy-3',5'-di-tert-butylphenyl)benzotriazole, 2-(2'-hydroxy-3'-tert-butyl-5'-methylphenyl)benzotriazole, 2-(2'-hydroxy-3',5'-di-tert-butylphenyl)-5-chlorobenzotriazole, 2-(2'-hydroxy-3'-(3",4",5",6"-tetrahydrophthalimidomethyl)- 5'-methylphenyl)benzotriazole, 2,2-methylenebis(4-(1,1,3,3-tetramethylbutyl)-6- (2H-benzotriazole-2-yl)phenol, 2-(2'-hydroxy-3'-tert-butyl-5'-methylphenyl)-5- chlorobenzotriazole, 2-(2'-hydroxy-3',5'-di-tert-butylphenyl)-5-chlorobenzotriazole, (2-(2'-hydroxy-3',5'-di-tert-amylphenyl)-5-chlorobenzotriazole, 2-(2'-hydroxy-3',5'-di-tert-butylphenyl)-5-chlorobenzotriazole, and (2-(2'-hydroxy-3',5'-di-tert-amylphenyl)-5-chlorobenzotriazle.

### (6-5-5) High-molecular-weight-type UV Absorber

As used herein, the term "high-molecular-weight-type UV absorber" is intended to include a compound having a weight average molecular weight of 500 or more. The weight average molecular weight can be measured using a gel permeation chromatography (GPC) system.
The high-molecular-weight-type UV absorber for use in the invention is preferably a compound represented by general formula (12) below, in particular, more preferably a high-molecular-weight benzotriazole-based UV absorber having a benzotriazole group.

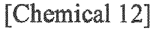

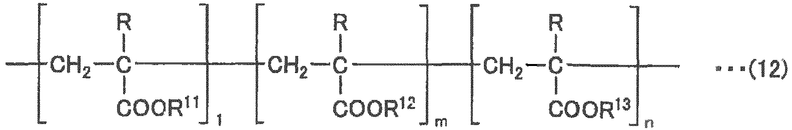

[0067] In the formula (12) above, R¹¹ represents a hydrogen atom or a methyl group, R¹² and R¹³ each represent a hydrogen atom, an alkyl group or an aryl group and R¹³ represents a benzophenone group or a benzotriazole group. The letters 1, m and n each represent an integer of 1 or more.
For example, the alkyl group represented by each of R¹² and R¹³ are linear, branched or cyclic alkyl group such as methyl, ethyl, propyl, isopropyl, butyl, isobutyl, sec-butyl, tert-butyl, pentyl, 1-methylbutyl, 2-methylbutyl, 3-methylbutyl, 1-ethylpropyl, 1,1-dimethylpropyl, 1,2-dimethylpropyl, 2,2-dimethylpropyl, hexyl, 1-methylpentyl, 2-methylpentyl, 3-methylpentyl, 4-methylpentyl, 1,1-dimethylbutyl, 2,2-dimethylbutyl, 3,3-dimethylbutyl, 1,2-dimethylbutyl, 1,3-dimethylbutyl, 2,3-dimethylbutyl, 1-ethylbutyl, 2-ethylbutyl, heptyl, octyl, nonyl, decyl, cyclopropyl, cyclobutyl, cyclopentyl, cyclohexyl, cycloheptyl, cyclooctyl, cyclononyl or cyclodecyl.
For example, the aryl group represented by each of R¹² and R¹³ is phenyl, tolyl, xylyl, ethylphenyl, benzyl or phenethyl.
Other high-molecular-weight-type UV absorbers include the compounds described in JP 2004-42614 A. Specific examples include [2-hydroxy-4-(methacryloyloxyethoxy)benzophenone]-methyl methacrylate copolymer, [2-hydroxy-4-(methacryloyloxymethoxy)benzophenone]-methyl methacrylate copolymer, [2-hydroxy-4-(methacryloyloxyoctoxy)benzophenone]-methyl methacrylate copolymer, [2-hydroxy-4-(methacryloyloxydodecyloxy)benzophenone]-methyl methacrylate copolymer, [2-hydroxy-4-(methacryloyloxybenziloxy)benzophenone]-methyl methacrylate copolymer,[2,2'-dihydroxy-4-(methacryloyloxyethoxy)benzophenone]-methyl methacrylate copolymer, [2,2'-dihydroxy-4-(methacryloyloxymethoxy)benzophenone]-methyl methacrylate copolymer, [2,2'-dihydroxy-4-(methacryloyloxyoctoxy)benzophenone]-methyl methacrylate copolymer, [2,2'-dihydroxy-4-(methacryloyloxybenziloxy)benzophenone]-methyl methacrylate copolymer, [2,2-dihydroxy-4-(methacryloyloxydodecyloxy)benzophenone]-methyl methacrylate copolymer, [2,2',4-trihydroxy-4'-(methacryloyloxyethoxy)benzophenone]-methyl methacrylate copolymer,[2,2',4-trihydroxy-4'-(methacryloyloxymethoxy)benzophenone]-methyl methacrylate copolymer, [2,2',4-trihydroxy-4'-(methacryloyloxyoctoxy)benzophenone]-methyl methacrylate copolymer, [2,2',4-trihydroxy-4'-(methacryloyloxydodecyloxy)benzophenone]-methyl methacrylate copolymer, [2,2',4-trihydroxy-4'-(methacryloyloxybenziloxy)benzophenone]-methyl methacrylate copolymer, [4-hydroxy-4'-(methacryloyloxyethoxy)benzophenone]-methyl methacrylate copolymer, [4-hydroxy-4'-(methacryloyloxymethoxy)benzophenone]-methyl methacrylate copolymer, [4-hydroxy-4'-(methacryloyloxyoctoxy)benzophenone]-methyl methacrylate copolymer, [4-hydroxy-4'-(methacryloyloxydodecyloxy)benzophenone]-methyl methacrylate copolymer, [4-hydroxy-4'-(methacryloyloxybenziloxy)benzophenone]-methyl methacrylate copolymer, [2-hydroxy-4'-methyl-4-(methacryloyloxyethoxy)benzophenone]-methyl methacrylate copolymer, [2-hydroxy-4'-methyl-4-(methacryloyloxymethoxy)benzophenone]-methyl methacrylate copolymer, [2-hydroxy-4'-methyl-4-(methacryloyloxyoctoxy)benzophenone]-methyl methacrylate copolymer, [2-hydroxy-4'-(methyl-4-methacryloyloxydodecyloxy)benzophenone]-methyl methacrylate copolymer, [2-hydroxy-4'-methyl-4-(methacryloyloxybenziloxy)benzophenone]-methyl methacrylate copolymer, [2-(2'-hydroxy-4'-methacryloyloxyethoxy)benzotriazole]-methyl methacrylate copolymer, and [2-(2'-hydroxy-4'-methacryloyloxyethoxy)-5-chlorobenzotriazole]-methyl methacrylate copolymer. Other high-molecular-weight-type UV absorbers with a molecular weight of 500 or more, such as 2,2'-methylenebis[6-(2H-benzotriazole-2-yl)-4-(1,1,3,3-tetramethylbutyl)phenol], are also preferred.

### (6-6) Antioxidant

The curable resin composition used for forming the hard coat layer is preferably added with an antioxidant.
By adding the antioxidant to the hard coat layer, weather resistance may be improved.
The antioxidant may be selected from the group consisting of hindered phenolic compound, hindered amine-based compound, and phosphorus-containing compound.
Specific examples of the hindered phenolic compound include *n*-octadecyl-3-(3,5-di-*t*-butyl-4-hydroxyphenyl)-propionate, *n*-octadecyl-3-(3,5-di-*t*-butyl-4-hydroxyphenyl) acetate, *n*-octadecyl-3,5-di-*t*-butyl-4-hydroxybenzoate, *n*-hexyl-3,5-di-t-butyl-4-hydroxyphenylbenzoate, *n*-dodecyl-3,5-di-*t*-butyl-4-hydroxyphenylbenzoate, neo-dodecyl-3-(3,5-di-*t*-butyl-4-hydroxyphenyl)propionate, dodecyl-β-(3,5-di-*t*-butyl-4-hydroxyphenyl)propionate, ethyl-α-(4-hydroxy-3,5-di-*t*-butylphenyl) isobutylate, octadecyl-α-(4-hydroxy-3,5-di-*t*-butylphenyl) isobutylate, octadecyl-α-(4-hydroxy-3,5-di-*t*-butyl-4-hydroxyphenyl) propionate, 2-(n-octylthio)ethyl-3,5-di-t-butyl-4-hydroxy-benzoate, 2-(*n*-octylthio)ethyl-3,5-di-*t*-butyl-4-hydroxyphenyl acetate, 2-(*n*-octadecyl-thio)ethyl-3,5-di-*t*-butyl-4-hydroxyphenyl acetate, 2-(*n*-octadecyl-thio)ethyl-3,5-di-*t*-butyl-4-hydroxy-benzoate, 2-(2-hydroxyethyl-thio)ethyl-3,5-di-t-butyl-4-hydroxybenzoate, diethyl-glycolbis-(3,5-di-*t*-butyl-4-hydroxy-phenyl)propionate, 2-(*n*-octadecyl-thio)ethyl-3-(3,5-di-*t*-butyl-4-hydroxyphenyl) propionate, stearylamide N,N-bis-[ethylene3-(3,5-di-*t*-butyl-4- hydroxyphenyl) propionate], *n*-butylimino-N,N-bis-[ethylene-3-(3,5-di-*t*-butyl-4-hydroxyphenyl)propionate], 2-(2-stearoyloxyethyl-thio)ethyl-3,5-di-t-butyl-4- hydroxybenzoate, 2-(2-stearoyloxyethylthio)ethyl-7-(3-methyl-5-t-butyl-4- hydroxyphenyl) heptanoate, 1,2-propylene glycol bis-[3-(3,5-di-*t*-butyl-4-hydroxy phenyl)propionate], ethylene glycol bis-[3-(3,5-di-*t*-butyl-4-hydroxyphenyl) propionate], neopentyl glycol bis-[3-(3,5-di-*t*-butyl-4-hydroxyphenyl) propionate], ethylene glycol bis-(3,5-di-*t*-butyl-4-hydroxyphenyl acetate), glycerin-1-*n*-octadecanoate-2,3-bis-(3,5-di-t-butyl-4- hydroxyphenyl acetate), pentaerythritol tetrakis-[3-(3',5'-di-*t*-butyl-4'-hydroxyphenyl) propionate], 3,9-bis- {2-[3-(3-*tert*-butyl-4-hydroxy-5-methylphenyl) propionyloxy]-1,1-dimethylethyl}-2,4,8,10-tetraoxaspiro[5.5] undecane, 1,1,1-trimethylolethane-tris[3-(3,5-di-*t*-butyl-4-hydroxypheny) propionate], sorbitol hexa[3-(3,5-di-t-butyl-4-hydroxyphenyl)propionate], 2-hydroxyethyl-7-(3-methyl-5-*t*-butyl-4-hydroxyphenyl) propionate, 2-stearoyloxyethyl-7-(3-methyl-5-*t*-butyl-4-hydroxyphenyl) heptanoate, 1,6-*n*-hexanediol-bis[(3',5'-di-*t*-butyl-4-hydroxyphenyl) propionate], and pentaerythritol tetrakis (3,5-di-*t*-butyl-4-hydroxy- hydrocinnamate). The phenolic compounds of these types are available, for example, under the trade name of "IRGANOX 1076" and "IRGANOX1010" from Ciba Japan Ltd.
Specific examples of the hindered amine-based compound include bis(2,2,6,6-tetramethyl-4-piperidyl) sebacate, bis(2,2,6,6-tetramethyl-4-piperidyl) succinate, bis(1,2,2,6,6-pentamethyl-4-piperidyl) sebacate, bis(N-octoxy-2,2,6,6-tetramethyl-4-piperidyl) sebacate, bis(N-benzyloxy-2,2,6,6-tetramethyl-4-piperidyl) sebacate, bis(N-cyclohexyloxy-2,2,6,6-tetramethyl-4-piperidyl) sebacate, bis(1,2,2,6,6-pentamethyl-4-piperidyl)2-(3,5-di-*t*-butyl-4-hydroxybenzyl)-2-butyl malonate, bis(1-acryloyl-2,2,6,6-tetramethyl-4-piperidyl)-2,2-bis(3,5-di-t-butyl-4-hydroxybenzyl)-2-butyl malonate, bis(1,2,2,6,6-pentamethyl-4-piperidyl) decanedioate, 2,2,6,6-tetramethyl-4-piperidyl methacrylate, 4-[3-(3,5-di-t-butyl-4-hydroxyphenyl)propionyloxy]-1-[2-(3-(3,5-di-*t*-butyl-4-hydroxyphenyl)pr opionyloxy)ethyl-]-2,2,6,6- tetramethylpiperidine, 2-methyl-2-(2,2,6,6-tetramethyl-4-piperidyl)amino-N-(2,2,6,6-tetramethyl-4-piperidyl)propionamide, tetrakis(2,2,6,6-tetramethyl-4-piperidyl)1,2,3,4-butane tetracarboxylate, and tetrakis(1,2,2,6,6-pentamethyl-4-piperidyl)1,2,3,4-butane tetracarboxylate.
Also polymer-type compounds may be used, specific examples of which include high molecular weight HALS configured by a plurality of piperidine rings bound to a triazine skeleton, such as N,N',N",N"'-tetrakis[4,6-bis[butyl-(N-methyl-2,2,6,6-tetramethylpiperidine-4-yl)amino]-triazine-2-yl]-4,7-diazadecane-1,10-diamine, polycondensate of dibutylamine and 1,3,5-triazine-N,N'-bis(2,2,6,6-tetramethyl-4-piperidyl)-1,6-hexamethylenediamine and N-(2,2,6,6-tetramethyl-4-piperidyl)butylamine, polycondensate of dibutylamine and 1,3,5-triazine and N,N'-bis(2,2,6,6-tetramethyl-4-piperidyl)butyl amine, poly[{(1,1,3,3-tetramethylbutyl)amino-1,3,5-triazine-2,4-diyl}{(2,2,6,6-tetramethyl-4-piperidyl)i mino}hexamethylene{(2,2,6,6-tetramethyl-4-piperidyl)imino}], polycondensate of 1,6-hexanediamine-N,N'-bis(2,2,6,6-tetramethyl-4-piperidyl) and morpholine-2,4,6-trichloro-1,3,5-triazine, and poly[(6-morpholino-*s*-triazine-2,4-diyl)[(2,2,6,6,-tetramethyl-4-piperidyl)imino]-hexamethylene[ (2,2,6,6-tetramethyl-4- piperidyl)imino]]; and compounds configured by a plurality of piperidine rings bound by ester bonds, such as polymer of dimethyl succinate and 4-hydroxy-2,2,6,6-tetramethyl-1-piperidine ethanol, and mixed estrified product of 1,2,3,4-butanetetracarboxylic acid and 1,2,2,6,6-pentamethyl-4- piperidinol and 3,9-bis(2-hydroxy-1,1-dimethylethyl-)-2,4,8,10-tetraoxaspiro[5,5]undecane, but not limited thereto.
Among them, polycondensate of dibutylamine and 1,3,5-triazine and N,N'-bis(2,2,6,6-tetramethyl-4-piperidyl) butylamine, poly[{(1,1,3,3-tetramethylbutyl)amino-1,3,5-triazine-2,4-diyl} {(2,2,6,6-tetramethyl-4-piperidyl)i mino}hexamethylene{(2,2,6,6-tetramethyl-4-piperidyl)imino}], and polymer of dimethyl succinate and 4-hydroxy-2,2,6,6-tetramethyl-1-piperidine ethanol, each having a number average molecular weight (Mn) of 2,000 to 5,000, are preferably used.
The hindered amine compounds of the above-described types are marketed, for example, under the trade names of "TUNUVIN144" and "TUNUVIN770" from Ciba Japan Ltd., and under the trade name of "ADK STAB LA-52" from ADEKA Corporation.
Specific examples of the phosphorus-containing compound include mono phosphite-based compounds such as triphenyl phosphite, diphenylisodecyl phosphite, phenyldiisodecyl phosphite, tris(nonylphenyl) phosphite, tris(dinonylphenyl) phosphite, tris(2,4-di-*t*-butylphenyl) phosphite, 10-(3,5-di-*t*-butyl-4-hydroxybenzyl)-9,10-dihydro-9-oxa-10-phosphaphenanthrene-10-oxide, 6-[3-(3-*t*-butyl-4-hydroxy-5-methylphenyl)propoxy]-2,4,8,10-tetra-*t*-butyldibenz[d,f][1,3,2]dioxaphosphepin, and tridecyl phosphite; diphosphite-based compounds such as 4,4'-butylidene-bis(3-methyl-6-*t*-butylphenyl-di-tridecyl phosphite), and 4,4'-isopropylidene-bis(phenyl-di-alkyl(C₁₂₋₁₅) phosphite); phosphonite-based compounds such as triphenylphosphonite, tetrakis (2,4-di-*tert*-butylphenyl)[1,1-biphenyl]-4,4'-diyl bisphosphonite, and tetrakis(2,4-di-*tert*-butyl-5- methylphenyl)[1,1-biphenyl]-4,4'- diylbisphosphonite; phosphinite-based compounds such as triphenyl phosphinite, and 2,6-dimethyl phenyldiphenyl phosphinite; and phosphine-based compounds such as triphenyl phosphine, and tris(2,6-dimethoxyphenyl) phosphine.
The phosphorus-containing compounds of these types are commercially available, for example, from Sumitomo Chemical Co. Ltd. under the trade name of "Sumilizer GP", from ADEKA Corporation under the trade names of "ADK STAB PEP-24G", "ADK STAB PEP-36" and "ADK STAB 3010", from Ciba Japan Ltd. under the trade name of "IRGAFOS P-EPQ", and from Sakai Chemical Industry Co. Ltd. under the trade name of "GSY-P101".

### (6-7) Solvent

The coating liquid used for forming the hard coat layer may be obtained by diluting the ionizing radiation-curable resin so as to adjust the solid content to 30 to 70% by mass, using at least one species of ethyl acetate, methyl ethyl ketone, methyl isobutyl ketone, and cyclohexanone as a solvent. If the solid content of the ionizing radiation-curable resin in the coating liquid is smaller than 30% by mass, the solvent concentration will be too dense and will be difficult to form a coated film of 10 to 30 µm thick when coated over the base. On the other hand, if the solid content of the ionizing radiation-curable resin in the coating liquid exceeds 70% by mass, the coating liquid will be too viscous and will make the coated film non-uniform to thereby impair the planarity.

An adhesive layer 7 and a second resin base 8 may be provided between the anti-corrosion layer 6 and the hard coat layer 9 as the film mirror 10a shown in FIG. 1.

### (7) Adhesive Layer

The adhesive layer formed in the film mirror 10a of the present invention may be of any type provided that it has the function of increasing the adhesiveness between the anti-corrosion layer and the transparent resin base. Thus, the adhesive layer should have smoothness and adhesive properties for bonding the anti-corrosion layer and the transparent resin base.
In view of adhesiveness, smoothness, the reflectance of the reflective material or the like, the adhesive layer preferably has a thickness of 0.01 to 3 µm and more preferably 0.1 to 1 µm.
In a case the adhesive layer is made of resin, the resin may be of any type capable of satisfying the above requirements for adhesiveness and smoothness. Polyester-based resin, acryl-based resin, melamine-based resin, epoxy-based resin, polyamide-based resin, vinyl chloride-based resin, vinyl chloride-vinyl acetate copolymer- based resin or the like may be used alone or a blend of any of these resins may be used. In view of weather resistance, a blend of polyester-based resin and melamine-based resin is preferred and more preferably, the blend is further mixed with a curing agent such as an isocyanate to form a Thermosetting resin composition. The adhesive layer 7 can be formed using a conventionally known coating method such as gravure coating, reverse coating, die coating or the like.
In a case the adhesive layer is made of metal oxide, the adhesive layer such as silicon oxide, aluminum oxide, silicon nitride, aluminum nitride, lanthanum oxide, lanthanum nitride or the like can be formed by any of various vacuum film forming methods. Examples of forming methods of the adhesive layer (film forming methods) include resistance heating vacuum deposition, electron beam heating vacuum deposition, ion plating, ion beam-assisted vacuum deposition and sputtering.

### (8) Transparent Resin Layer

The transparent resin layer is made of a resin material having optical transparency and contains an ultraviolet-ray absorber.
The resin material for use in the transparent resin layer is not restricted and various conventionally known synthetic resins that can maintain transparency when formed into a thin film may be used. Examples of such resins include polyesters such as polyethylene terephthalate (PET) and polyethylene naphthalate (PEN), polyethylene, polypropylene, cellophane, cellulose esters or derivatives thereof, such as cellulose diacetate, cellulose triacetate (TAC), cellulose acetate butyrate, cellulose acetate propionate (CAP), cellulose acetate phthalate, and cellulose nitrate, polyvinylidene chloride, polyvinyl alcohol, polyethylene vinyl alcohol, syndiotactic polystyrene, polycarbonate, norbornene resin, polymethylpentene, polyether ketone, polyimide, polyethersulfone (PES), polysulfones, polyether ketone imide, polyamide, fluororesin, nylon, poly(methyl methacrylate), acrylic resin or polyarylates, and cycloolefin resins such as ARTON (trade name, manufactured by JSR Corporation) and APEL (trade name, manufactured by Mitsui Chemicals, Inc.).

For example, the method of forming the transparent resin layer may be a melt casting method, a film forming method by extrusion molding, or a coating method. A conventionally known resin film is commercially available as the transparent resin layer formed by such a method as melt casting or extrusion molding. When forming the transparent resin layer 8 by a coating method, various conventional coating methods such as a spray coating method, spin coating or bar coating may be used. The transparent layer may be formed by applying the material for forming the transparent resin layer directly to a light-incidence-side surface of a reflective layer or to a surface of a component layer (e.g., an anti-corrosion layer) provided on the light-incidence side of a silver reflective layer.
Such a coating method can form a transparent resin layer with higher smoothness. Specifically, such a coating method can form a transparent resin layer having a center line average roughness (Ra) of 3 nm or more and 20 nm or less. In other words, the transparent resin layer having a center line average roughness falling within the value range may be deemed to be provided not by bonding a transparent resin film, which is produced by melt film forming, with an adhesive layer but by a coating method.
The transparent resin layer preferably has a thickness of 10 to 150 µm. The thickness of the transparent resin layer is more preferably from 20 to 100 µm, and even more preferably from 40 to 100 µm.
The center line average roughness (Ra) as an index of the smoothness of the transparent resin layer can be determined by the method based on JIS B 0601-1982.

Among the resin materials listed above, acrylic resin is advantageously used as a material for forming the transparent resin layer.
When acrylic resin is used to form the transparent resin layer, fine particles of a plasticizer may be added to the acrylic resin so that a soft, less breakable and transparent acrylic resin layer can be obtained because the acrylic resin is hard. A preferred example of the plasticizer is butyl rubber or butyl acrylate.

The transparent acrylic resin layer is preferably composed mainly of methacrylic resin. The methacrylic resin is a methacrylate-based polymer, which may be a homopolymer of a methacrylate or a copolymer of 50% by weight or more of a methacrylate and 50% by weight or less of any other monomer. Usually, an alkyl methacrylate is used as the methacrylate. In particular, poly(methyl methacrylate) resin (PMMA) is preferably used as the methacrylic resin.

The monomer composition of the methacrylic resin is preferably 50 to 100% by weight of a methacrylate, 0 to 50% by weight of an acrylate and 0 to 49% by weight of any other monomer, and more preferably 50 to 99.9% by weight of a methacrylate, 0.1 to 50% by weight of an acrylate and 0 to 49% by weight of any other monomer, with respect to the weight of all monomers.

Examples of the alkyl methacrylate include methyl methacrylate, ethyl methacrylate, butyl methacrylate, and 2-ethylhexyl methacrylate, and the alkyl group generally has 1 to 8 carbon atoms, preferably 1 to 4 carbon atoms. In particular, methyl methacrylate is preferably used.

Examples of the alky acrylate include methyl acrylate, ethyl acrylate, butyl acrylate, and 2-ethylhexyl acrylate, and the alkyl group generally has 1 to 8 carbon atoms, preferably 1 to 4 carbon atoms.

The monomer other than the alkyl methacrylate and the alkyl acrylate may be a monofunctional monomer, specifically, a compound having one polymerizable carbon-carbon double bond in its molecule, or may be a polyfunctional monomer, specifically, a compound having at least two polymerizable carbon-carbon double bonds in its molecule. A monofunctional monomer is preferably used. Examples of such a monofunctional monomer include aromatic alkenyl compounds such as styrene, α-methylstyrene, and vinyltoluene, and alkenyl cyanides such as acrylonitrile and methacrylonitrile. Example of the polyfunctional monomer include polyhydric alcohol esters of unsaturated polycarboxylic acids such as ethylene glycol dimethacrylate, butanediol dimethacrylate and trimethylolpropane triacrylate, alkenyl esters of unsaturated carboxylic acids such as allyl acrylate, allyl methacrylate and allyl cinnamate, polyalkenyl esters of polybasic acids such as diallyl phthalate, diallyl maleate, triallyl cyanurate and triallyl isocyanurate, and aromatic polyalkenyl compounds such as divinylbenzene.

If necessary, two or more of the alkyl methacrylates, two or more of the alkyl acrylates, and two or more other monomers may be used.

In view of the heat resistance of the film, the methacrylic resin preferably has a glass transition temperature of 40°C or higher and more preferably 60°C or higher. The glass transition temperature can be appropriately set by controlling the type or content of the monomers.

The methacrylic resin can be prepared by suspension polymerization, emulsion polymerization, bulk polymerization, or other types of polymerization of the constituent monomers. In this process, a chain transfer agent is preferably used during the polymerization so that an appropriate glass transition temperature can be obtained and so that an appropriate level of viscosity for appropriate film formability can be obtained. The amount of the chain transfer agent may be determined as appropriate depending on the type or content of the monomers.
Examples of the ultraviolet absorber may include those generally listed above for the "hard coat layer".

Besides the above, a compound having the function of converting the energy of ultraviolet light to intramolecular vibration energy and emitting the vibration energy as thermal energy may also be used as an ultraviolet absorber. The ultraviolet absorber may also be used in combination with a compound that produces an effect when used in combination with an antioxidant or a colorant or the like or may also be used in combination with a light stabilizer, called a quencher, capable of acting as a light energy-converting agent. When any of the above ultraviolet absorbers is used, the light absorption wavelength of the ultraviolet absorber should be selected not to overlap the effective wavelength of the photopolymerization initiator. When a common ultraviolet absorber is used, a photopolymerization initiator that produces radicals when exposed to visible light can be effectively used.

If necessary, two or more of the above ultraviolet absorbers may be used. If necessary, any other ultraviolet absorber than the above ultraviolet absorbers, such as a salicylic acid derivative, substituted acrylonitrile, or a nickel complex may also be added.

The content of the ultraviolet absorber in the transparent resin layer is preferably from 0.1 to 20% by weight, more preferably from 1 to 15% by weight and even more preferably from 3 to 10% by weight. The ultraviolet absorber content of the transparent resin layer per unit film area is preferably from 0.17 to 2.28 g/m² and more preferably from 0.4 to 2.28 g/m² or more. When the content is in the above range, sufficient weather resistance can be provided while stains of the roll or the film can be prevented, which would otherwise be caused by bleed-out of the ultraviolet absorber.
The ultraviolet absorber-containing transparent resin layer may also contain an antioxidant for preventing its degradation. Examples of such an antioxidant may include those generally listed above for the "hard coat layer".

An antistatic agent may also be added to the transparent resin layer to impart antistatic properties thereto.
A phosphorus-based flame retardant may also be added to the transparent resin layer. The phosphorus-based flame retardant for use in this layer may be one selected from red phosphorus, triaryl phosphate, diaryl phosphate, monoaryl phosphate, an arylphosphonic acid compound, an arylphosphine oxide compound, condensed aryl phosphate, halogenated alkyl phosphate, halogen-containing condensed phosphate, halogen-containing condensed phosphonate, and halogen-containing phosphite, or a mixture of two or more of the above.
Specific examples of the flame retardant include triphenyl phosphate, 9,10-dihydro-9-oxa-10-phosphaphenanthrene-10-oxide, phenyl phosphonate, tris(β-chloroethyl)phosphate, tris(dichloropropyl)phosphate, and tris(tribromoneopentyl)phosphate.

### (9) Sticky Layer

The film mirror preferably includes a sticky layer for bonding the film mirror to a support.
A dry laminating agent, wet laminating agent, sticky agent, heat-seal agent, hot-melt agent or the like may be used for the sticky layer without any limitations. A polyester-based resin, urethane-based resin, polyvinylacetate-based resin, acryl-based resin, nitrile rubber or the like may be used as the sticky agent. The laminating method is not particularly limited and a continuous method such as a roll system is preferable from the viewpoint of cost and productivity. Thickness of the sticky layer may be generally about 1 to 100 µm, and more preferably 1 to 50 µm from the viewpoint of efficiency of stickiness, drying speed and the like. As a specific material used for the sticky layer, "SK-dyne series" (from Soken Chemical Engineering Co., Ltd.), Oribain BPW series and BPS series (from Toyo Ink Co., Ltd.) and "ARKON", "SUPER ESTER" and "HYPALE" (from Arakawa Chemical Industries, Ltd.) may be preferably used.

### (10) Reflecting Device for Solar Thermal Power Generation

A reflecting device for solar thermal power generation 20a, 20b or 20c is composed of at least a film mirror 10a, 10b or 10c and a metal base as a support as shown in FIGs. 1, 2 or 3.

### (10-1) Support

A metallic sheet, a resin sheet, or a metal-resin composite sheet may be used as the support in the reflecting device for solar thermal power generation according to the invention. The metallic sheet may be a sheet made of a metallic material with high thermal conductivity, such as a steel sheet, a copper sheet, an aluminum sheet, an aluminum-plated steel sheet, an aluminum alloy-plated steel sheet, a copper-plated steel sheet, a tin-plated steel sheet, a chromium-plated steel sheet, or a stainless steel sheet. The resin sheet may be an acrylic resin sheet, a urethane resin sheet, a polystyrene resin sheet, a polyimide resin sheet, a phenolic resin sheet, a polycarbonate resin sheet, an alicyclic hydrocarbon resin sheet, a polypropylene resin sheet, a polyolefin resin sheet, a melamine resin sheet, or an ABS resin sheet. The metal-resin composite sheet may be a laminate of the metallic sheet and the resin sheet or a laminate of the metallic sheet and resin foam. As used herein, the term "resin foam" means porous resin, examples of which include polystyrene-based, polyolefin-based, polyurethane-based, melamine resin-based, and polyimide-based materials.

### EXAMPLE 1

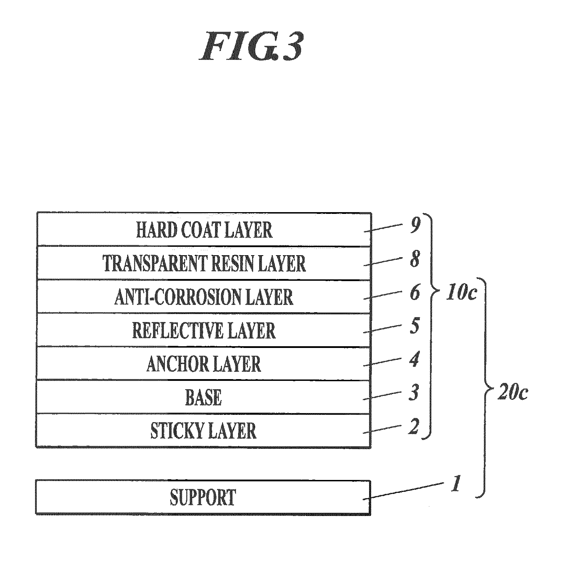

The present invention will now be explained with reference to examples and comparative examples. However, the present invention is not limited to these examples. In the description of examples and comparative examples, notations of "part" and "%" mean "part by mass" and "% by mass", respectively, unless otherwise specifically noted.
The reflecting devices for solar thermal power generation No. 1 to 11 correspond to the film mirror type 10a shown in FIG. 1, the reflecting devices No. 12 to 21 correspond to the film mirror type 10b shown in FIG. 2 and the reflecting devices No. 22 to 33 correspond to the film mirror type 10c shown in FIG 3.

### [Example 1]

### (Manufacturing of Film Mirror for Solar Thermal Power Generation No. 1)

A bi-axially oriented polyester film (polyethylene terephthalate film, 100 µm thick) was used as the base 3. On one surface of the polyethylene terephthalate film, a resin composed of a 20:1:1:2 (solid content basis) mixture of a polyester-based resin, a melamine-based resin, a TDI-based isocyanate, and a HMDI-based isocyanate was coated by gravure coating to thereby form an anchor layer 4 of 0.1 µm thick, and a silver reflective layer of 80 nm thick was formed on the anchor layer 4 as the reflective layer 5 by vacuum deposition. On the reflective layer 5, a liquid composed of OrigiZug #100 (clear) which is an acrylic resin having an amino group in a side chain, Polyhard G21 as a curing agent containing a silane coupling agent having an epoxy group, and Origin thinner #111 No.2 as a solvent (all from Origin Electric Co. Ltd.) by 40:10:20 by mass ratio was coated by gravure coating and dried for 30 minutes at 80°C to stack a film of 0.1 µm thick as an anti-corrosion layer 6 composed of an acrylic silicone resin. An acrylic resin adhesive (Showa Highpolymer Co., Ltd.) was subsequently coated in 10 µm thickness as an adhesive layer 7 on the anti-corrosion layer 6, and Tecnoloy S000 (Sumitomo Chemical Co., Ltd.) of an acrylic resin containing no UV absorber was stacked in 100 µm thickness as a transparent resin layer 8 on the adhesive layer 7. Next, on the transparent resin layer 8, Lioduras LCH (Toyo Ink Co. Ltd.), added with ZX-049 (Fuji Kasei Kogyo Co. Ltd.) by 0.1 % by mass to the solid resin content as a fluorine-containing leveling agent and Tinuvin 477 (Ciba Japan Ltd.) by 1.0% by mass to the solid resin content as a Triazine-based UV absorber, was coated by gravure coating to a wet thickness of 40 µm and the coating was heat-treated for 2 hours at 80°C to form a hard coat layer 9.
A film mirror for solar thermal power generation No. 1 was thus manufactured.

### [Example 2]

### (Manufacturing of Film Mirror for Solar Thermal Power Generation No. 2)

A film mirror for solar thermal power generation No.2 was manufactured similarly to the film mirror for solar thermal power generation No.1, except that an anti-corrosion layer 6 was formed by using a solution composed of BECKOLITE M-6652-60 solution (DIC Corporation) of a silicone alkyd resin and 2- glycidoxyethyltriethoxysilane (Shin-Etsu Chemical Co., Ltd.) as a silane coupling agent having an epoxy group mixed by 40:1 by mass ratio instead of using the mixed solution, as a coating solution for the anti-corrosion layer 6, of OrigiZug #100 (clear), Polyhard G21 (curing agent) containing a silane coupling agent having an epoxy group and Origin thinner #111 No.2 as a solvent.

### [Example 3]

### (Manufacturing of Film Mirror for Solar Thermal Power Generation No. 3)

A film mirror for solar thermal power generation No.3 was manufactured using the same process for forming the solar thermal power generation No.1 except that a coating solution for forming the anti-corrosion layer 6 added with Tinuvin 234 (BASF A.G.) by 5% by mass with respect to the solution was used.

### [Example 4]

### (Manufacturing of Film Mirror for Solar Thermal Power Generation No. 4)

A film mirror for solar thermal power generation No.4 was manufactured using the same process for forming the solar thermal power generation No.3 except that a solution for forming the hard coat layer 9 added with Tinuvin 152 as an antioxidant by 1.5% by mass to the resin solid content was used.

### [Example 5]

### (Manufacturing of Film Mirror for Solar Thermal Power Generation No. 5)

A film mirror for solar thermal power generation No.5 was manufactured using the same process for forming the solar thermal power generation No.4 except that Tecnoloy S001 (Sumitomo Chemical Co., Ltd.) having a thickness of 100 µm containing a UV absorber was used as a transparent resin layer 8.

### [Comparative Example 1]

### (Manufacturing of Film Mirror for Solar Thermal Power Generation No. 6)

A film mirror for solar thermal power generation No.6 was manufactured using the same process for forming the solar thermal power generation No. 5 except that a solution without a silane coupling agent and a corrosion preventing agent was used for forming an anti-corrosion layer 6.

### [Comparative Example 2]

### (Manufacturing of Film Mirror for Solar Thermal Power Generation No. 7)

A film mirror for solar thermal power generation No. 7 was manufactured using the same process for forming the solar thermal power generation No.2 except that a solution without silane coupling agent was used for forming an anti-corrosion layer 6, Tecnoloy S001 (Sumitomo Chemical Co., Ltd.) having a thickness of 100 µm and containing a UV absorber was used as a transparent resin layer 8, and a solution added with Tinuvin 152 as an antioxidant by 1.5% by mass to the resin solid content was used for forming a hard coat layer 9.

### [Comparative Example 3]

### (Manufacturing of Film Mirror for Solar Thermal Power Generation No. 8)

A film mirror for solar thermal power generation No. 8 was manufactured using the same process for forming the solar thermal power generation No.7 except that a MEK solution of PMMA (Mitsubishi Rayon Co., Ltd.) having a molecular weight of 30000 diluted to be 15% by mass was used for forming an anti-corrosion layer 6 in place of using the solution composed of BECKOLITE M-6652-60 solution (DIC Corporation) of a silicone alkyd resin and 2-glycidoxyethyltriethoxysilane (Shin-Etsu Chemical Co., Ltd.) as a silane coupling agent having an epoxy group mixed by 40:1 by mass ratio.

### [Comparative Example 4]

### (Manufacturing of Film Mirror for Solar Thermal Power Generation No. 9)

A film mirror for solar thermal power generation No.9 was manufactured using the same process for forming the solar thermal power generation No.5 except that the hard coat layer 9 was not provided.

### [Comparative Example 5]

### (Manufacturing of Film Mirror for Solar Thermal Power Generation No. 10)

A film mirror for solar thermal power generation No. 10 was manufactured similarly to the film mirror for solar thermal power generation No.9, except that an anti-corrosion layer 6 was formed by using a solution composed of BECKOLITE M-6652-60 solution (DIC Corporation) of a silicone alkyd resin and 2-glycidoxyethyltriethoxysilane (Shin-Etsu Chemical Co., Ltd.) as a silane coupling agent having an epoxy group mixed by 40:1 by mass ratio in place of using the mixed solution, as a coating solution for the anti-corrosion layer 6, of OrigiZug #100 (clear), Polyhard G21 (curing agent) containing a silane coupling agent having an epoxy group and Origin thinner #111 No.2 as a solvent.

### [Comparative Example 6]

### (Manufacturing of Film Mirror for Solar Thermal Power Generation No. 11)

A film mirror for solar thermal power generation No.11 was manufactured similarly to the film mirror for solar thermal power generation No.9, except that a MEK solution of PMMA (Mitsubishi Rayon Co., Ltd.) having a molecular weight of 30000 diluted to be 15% by mass was used as a coating solution for the anti-corrosion layer 6 in place of using the mixed solution composed of OrigiZug #100 (clear), Polyhard G21 (curing agent) containing a silane coupling agent having an epoxy group and Origin thinner #111 No.2 as a solvent.

### [Example 6]

### (Manufacturing of Film Mirror for Solar Thermal Power Generation No. 12)

A film mirror for solar thermal power generation No. 12 was manufactured using the same process for forming the solar thermal power generation No.1 except that the adhesive layer 7 and the transparent resin layer 8 were not provided.

### [Example 7]

### (Manufacturing of Film Mirror for Solar Thermal Power Generation No. 13)

A film mirror for solar thermal power generation No.13 was manufactured using the same process for forming the solar thermal power generation No.2 except that the adhesive layer 7 and the transparent resin layer 8 were not provided.

### [Example 8]

### (Manufacturing of Film Mirror for Solar Thermal Power Generation No. 14)

A film mirror for solar thermal power generation No.14 was manufactured using the same process for forming the solar thermal power generation No.3 except that the adhesive layer 7 and the transparent resin layer 8 were not provided.

### [Example 9]

### (Manufacturing of Film Mirror for Solar Thermal Power Generation No. 15)

A film mirror for solar thermal power generation No.15 was manufactured using the same process for forming the solar thermal power generation No.4 except that the adhesive layer 7 and the transparent resin layer 8 were not provided.

### [Comparative Example 7]

### (Manufacturing of Film Mirror for Solar Thermal Power Generation No. 16)

A film mirror for solar thermal power generation No.16 was manufactured similarly to the film mirror for solar thermal power generation No. 15, except that a silane coupling agent was not added to the solution for forming the anti-corrosion layer 6 and that Tinuvin 152 as an antioxidant was added to the solution for forming the hard coat layer 9 by 1.5 % by mass to the resin solid content.

### [Comparative Example 8]

### (Manufacturing of Film Mirror for Solar Thermal Power Generation No. 17)

A film mirror for solar thermal power generation No.17 was manufactured similarly to the film mirror for solar thermal power generation No.16, except that an anti-corrosion layer 6 was formed by using a solution composed of BECKOLITE M-6652-60 solution (DIC Corporation) of a silicone alkyd resin and 2- glycidoxyethyltriethoxysilane (Shin-Etsu Chemical Co., Ltd.) as a silane coupling agent having an epoxy group mixed by 40:1 by mass ratio in place of using the mixed solution, as a coating solution for forming the anti-corrosion layer 6, of OrigiZug #100 (clear), Polyhard G21 (curing agent) containing a silane coupling agent having an epoxy group and Origin thinner #111 No.2 as a solvent.

### [Comparative Example 9]

### (Manufacturing of Film Mirror for Solar Thermal Power Generation No. 18)

A film mirror for solar thermal power generation No.18 was manufactured similarly to the film mirror for solar thermal power generation No.16, except that a MEK solution of PMMA (Mitsubishi Rayon Co., Ltd.) having a molecular weight of 30000 diluted to 15% by mass was used as a coating solution for forming the anti-corrosion layer 6 in place of using the mixed solution composed of OrigiZug #100 (clear), Polyhard G21 (curing agent) containing a silane coupling agent having an epoxy group and Origin thinner #111 No.2 as a solvent.

### [Comparative Example 10]

### (Manufacturing of Film Mirror for Solar Thermal Power Generation No. 19)

A film mirror for solar thermal power generation No.19 was manufactured using the same process for forming the solar thermal power generation No.9 except that the adhesive layer 7, the transparent resin layer 8 and the hard coat layer 9 were not provided.

### [Comparative Example 11]

### (Manufacturing of Film Mirror for Solar Thermal Power Generation No. 20)

A film mirror for solar thermal power generation No.20 was manufactured using the same process for forming the solar thermal power generation No. 10 except that the adhesive layer 7, the transparent resin layer 8 and the hard coat layer 9 were not provided.

### [Comparative Example 12]

### (Manufacturing of Film Mirror for Solar Thermal Power Generation No. 21)

A film mirror for solar thermal power generation No.21 was manufactured using the same process for forming the solar thermal power generation No.11 except that the adhesive layer 7, the transparent resin layer 8 and the hard coat layer 9 were not provided.

### [Example 10]

### (Manufacturing of Film Mirror for Solar Thermal Power Generation No. 22)

A bi-axially oriented polyester film (polyethylene terephthalate film, 100 µm thick) was used as the base 3. On one surface of the polyethylene terephthalate film, a resin composed of a 20:1:1:2 (solid content basis) mixture of a polyester-based resin, a melamine-based resin, a TDI-based isocyanate, and a HMDI-based isocyanate was coated by gravure coating to thereby form an anchor layer 4 of 0.1 µm thick, and a silver reflective layer 5 of 80 nm thick was formed as the silver reflective layer by vacuum deposition. On the reflective layer 5, a liquid composed of OrigiZug #100 (clear) which is an acrylic resin having an amino group in a side chain, Polyhard G21 as a curing agent containing a silane coupling agent having an epoxy group, and Origin thinner #111 No.2 as a solvent (all from Origin Electric Co. Ltd.) by 40:10:20 by mass ratio was coated by gravure coating and dried for 30 minutes at 80°C to stack a film of 0.1 µm thick as an anti-corrosion layer 6 composed of an acrylic silicone resin.

Next, a transparent resin layer 8 containing UV absorber was formed on the anti-corrosion layer 6 by preparing a MEK solution in which an acrylic resin (ACRYPET VH by Mitsubishi Rayon Co., Ltd.) and a UV absorber (Tinuvin 477 by BASF A.G.) were dissolved at 95:5 (solid content ratio) and in 20% by solid content, applying the solution on the silver reflective layer by a film thickness of 30µm using an extruding coater and drying (90°C, 1 minute).
Next, on the transparent resin layer 8, Lioduras LCH (Toyo Ink Co. Ltd.) as a UV curable resin, added with ZX-049 (Fuji Kasei Kogyo Co. Ltd.) by 0.1 % by mass to the resin solid content as a fluorine-containing leveling agent and Tinuvin 477 (Ciba Japan Ltd.) by 1.0% by mass to the resin solid content as a Triazine-based UV absorber, was coated by gravure coating to a wet thickness of 40 µm, and the coating was heat-treated for 2 hours at 80°C to form a hard coat layer 9.
A film mirror for solar thermal power generation No. 22 was thus manufactured.

### [Example 11]

### (Manufacturing of Film Mirror for Solar Thermal Power Generation No. 23)

A film mirror for solar thermal power generation No.23 was manufactured similarly to the film mirror for solar thermal power generation No. 10, except that an anti-corrosion layer 6 was formed by using a solution composed of BECKOLITE M-6652-60 solution (DIC Corporation) of a silicone alkyd resin and 2- glycidoxyethyltriethoxysilane (Shin-Etsu Chemical Co., Ltd.) as a silane coupling agent having an epoxy group mixed by 40:1 by mass ratio instead of using the mixed solution, as a coating solution for the anti-corrosion layer 6, of OrigiZug #100 (clear), Polyhard G21 (curing agent) containing a silane coupling agent having an epoxy group and Origin thinner #111 No.2 as a solvent.

### [Example 12]

### (Manufacturing of Film Mirror for Solar Thermal Power Generation No. 24)

A film mirror for solar thermal power generation No.24 was manufactured using the same process for forming the solar thermal power generation No. 10 except that a coating solution for forming the anti-corrosion layer 6 added with Tinuvin 234 (BASF A.G) by 5% by mass to the solution was used.

### [Example 13]

### (Manufacturing of Film Mirror for Solar Thermal Power Generation No. 25)

A film mirror for solar thermal power generation No.25 was manufactured using the same process for forming the solar thermal power generation No.24 except that a solution for forming the hard coat layer 9 added with Tinuvin 152 as an antioxidant by 1.5% by mass to the resin solid content was used.

### [Example 14]

### (Manufacturing of Film Mirror for Solar Thermal Power Generation No. 26)

A film mirror for solar thermal power generation No.26 was manufactured using the same process for forming the solar thermal power generation No.25 except that Tecnoloy S001 (Sumitomo Chemical Co., Ltd.) having a thickness of 100 µm containing a UV absorber was used as a transparent resin layer 8.

### [Comparative Example 13]

### (Manufacturing of Film Mirror for Solar Thermal Power Generation No. 27)

A film mirror for solar thermal power generation No.27 was manufactured using the same process for forming the solar thermal power generation No.26 except that a solution without a silane coupling agent and a corrosion preventing agent was used for forming an anti-corrosion layer 6.

### [Comparative Example 14]

### (Manufacturing of Film Mirror for Solar Thermal Power Generation No. 28)

A film mirror for solar thermal power generation No.28 was manufactured using the same process for forming the solar thermal power generation No.23 except that a solution without silane coupling agent was used for forming an anti-corrosion layer 6, Tecnoloy S001 (Sumitomo Chemical Co., Ltd.) having a thickness of 100 µm containing a UV absorber was used as a transparent resin layer 8, and a solution added with Tinuvin 152 as an antioxidant by 1.5% by mass to the resin solid content was used for forming a hard coat layer 9.

### [Comparative Example 15]

### (Manufacturing of Film Mirror for Solar Thermal Power Generation No. 29)

A film mirror for solar thermal power generation No.29 was manufactured using the same process for forming the solar thermal power generation No.28 except that a MEK solution of PMMA (Mitsubishi Rayon Co., Ltd.) having a molecular weight of 30000 diluted to be 15% by mass was used for forming an anti-corrosion layer 6 in place of using the solution composed of BECKOLITE M-6652-60 solution (DIC Corporation) of a silicone alkyd resin and 2-glycidoxyethyltriethoxysilane (Shin-Etsu Chemical Co., Ltd.) as a silane coupling agent having an epoxy group mixed by 40:1 by mass ratio.

### [Comparative Example 16]

### (Manufacturing of Film Mirror for Solar Thermal Power Generation No. 30)

A film mirror for solar thermal power generation No.30 was manufactured using the same process for forming the solar thermal power generation No.26 except that the hard coat layer 9 was not provided.

### [Comparative Example 17]

### (Manufacturing of Film Mirror for Solar Thermal Power Generation No. 31)

A film mirror for solar thermal power generation No.31 was manufactured similarly to the film mirror for solar thermal power generation No.30, except that an anti-corrosion layer 6 was formed by using a solution composed of BECKOLITE M-6652-60 solution (DIC Corporation) of a silicone alkyd resin and 2- glycidoxyethyltriethoxysilane (Shin-Etsu Chemical Co., Ltd.) as a silane coupling agent having an epoxy group mixed by 40:1 by mass ratio in place of using the mixed solution, as a coating solution for the anti-corrosion layer 6, of OrigiZug #100 (clear), Polyhard G21 (curing agent) containing a silane coupling agent having an epoxy group and Origin thinner #111 No.2 as a solvent.

### [Comparative Example 18]

### (Manufacturing of Film Mirror for Solar Thermal Power Generation No. 32)

A film mirror for solar thermal power generation No.32 was manufactured similarly to the film mirror for solar thermal power generation No.30, except that a MEK solution of PMMA (Mitsubishi Rayon Co., Ltd.) having a molecular weight of 30000 diluted to be 15% by mass was used as a coating solution for the anti-corrosion layer 6 in place of using the mixed solution composed of OrigiZug #100 (clear), Polyhard G21 (curing agent) containing a silane coupling agent having an epoxy group and Origin thinner #111 No.2 as a solvent.

### [Evaluation of Reflecting Devices for Solar Thermal Power Generation/Film Mirrors for Solar Thermal Power Generation]

Weather resistance was evaluated for each of the film mirrors for solar thermal power generation No.1 to No.21 above manufactured by evaluating film adhesiveness after UV degradation treatment, discoloration of silver layer after UV degradation treatment, reflectance after UV degradation treatment and sulfuration resistance according to the methods described below.

### [Evaluation of Film Adhesiveness after UV Degradation Treatment]

Each sample was subjected to ultraviolet irradiation at 150 mW in an environment at 65°C for 96 hours using I-Super UV Tester manufactured by Iwasaki Electro Co., Ltd. After the treatment, the outermost surface layer of the film mirror of each sample was rubbed back-and-forth 10 times with steel wool of # 0000 under a load of 1 kg/cm² at a stroke of 100 mm and a rate of 30 mm/second. The sample was then subjected to a tape-stripping test using a 100 cross-cut grid in conformance with the JIS K5400 to evaluate film adhesiveness according to the following criteria.
⊚: 0 film square stripped
○: 1-5 film squares stripped
Δ: 6-10 film squares stripped
x: 11 or more film squares stripped

### [Evaluation of Discoloration of Silver Layer after UV Degradation Treatment]

Each sample was subjected to ultraviolet irradiation at 150 mW in an environment at 65°C for 7 days using I-Super UV Tester manufactured by Iwasaki Electro Co., Ltd. After that it was evaluated whether or not red-purple discoloration of the silver layer was observed by visible observation under a fluorescent lamp.
○: no discoloration observed
x: discoloration observed

### [Evaluation of Reflectance after UV Degradation Treatment]

Each sample was subjected to ultraviolet irradiation in an environment at 65°C for 7 days using I-Super UV Tester manufactured by Iwasaki Electro Co., Ltd. The regular reflectance of each sample was then measured with a "regular reflectance measurement" method described below and evaluated the reflectance after UV degradation treatment according to the following criteria.
The "regular reflectance" was measured using a spectrophotometer UV-265 manufactured by Shimadzu Corporation modified with integrating sphere reflectance accessories, in which the angle of incident light was adjusted to 5° with respect to the normal to the reflective surface. The average reflectance at wavelengths from 350 nm to 700 nm was determined for the evaluation.
⊚: average regular reflectance is 92% or more
○: average regular reflectance is 87% or more and less than 92%
Δ: average regular reflectance is 82% or more and less than 87%
x: average regular reflectance is less than 82%

### [Evaluation of Sulfuration Resistance]

Each sample was subjected to ultraviolet irradiation in an environment at 65°C for 7 days using I-Super UV Tester manufactured by Iwasaki Electro Co., Ltd and the edge surface of the sample was sealed with a waterproof tape. The sample was then immersed in a 10% ammonium sulfide solution in 24 hours and the regular reflectance was measured by the "regular reflectance measurement" method above described to evaluate sulfuration resistance according to the following criteria.
⊚: average regular reflectance is 87% or more
○: average regular reflectance is 82% or more and less than 87%
Δ: average regular reflectance is 77% or more and less than 82%
x: average regular reflectance is less than 77%

Results of the evaluations of film adhesiveness after UV degradation treatment, discoloration of silver layer after UV degradation treatment, reflectance after UV degradation treatment and sulfuration resistance are shown in Tables 1-1, 1-2, 2, 3-1 and 3-2.

[Table 1-1]

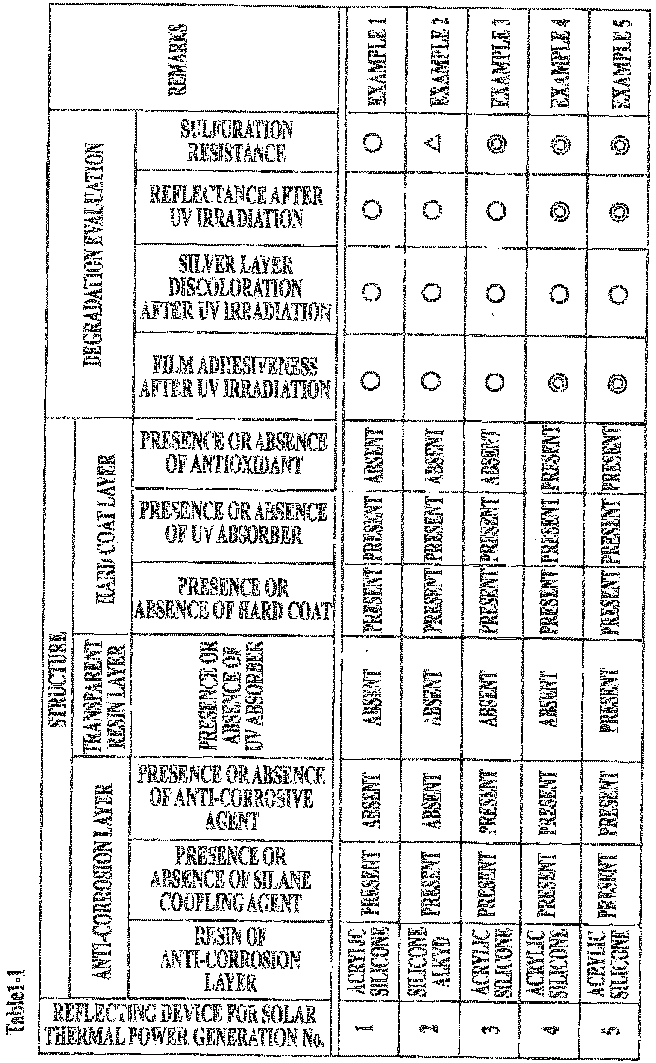

[Table 1-2]

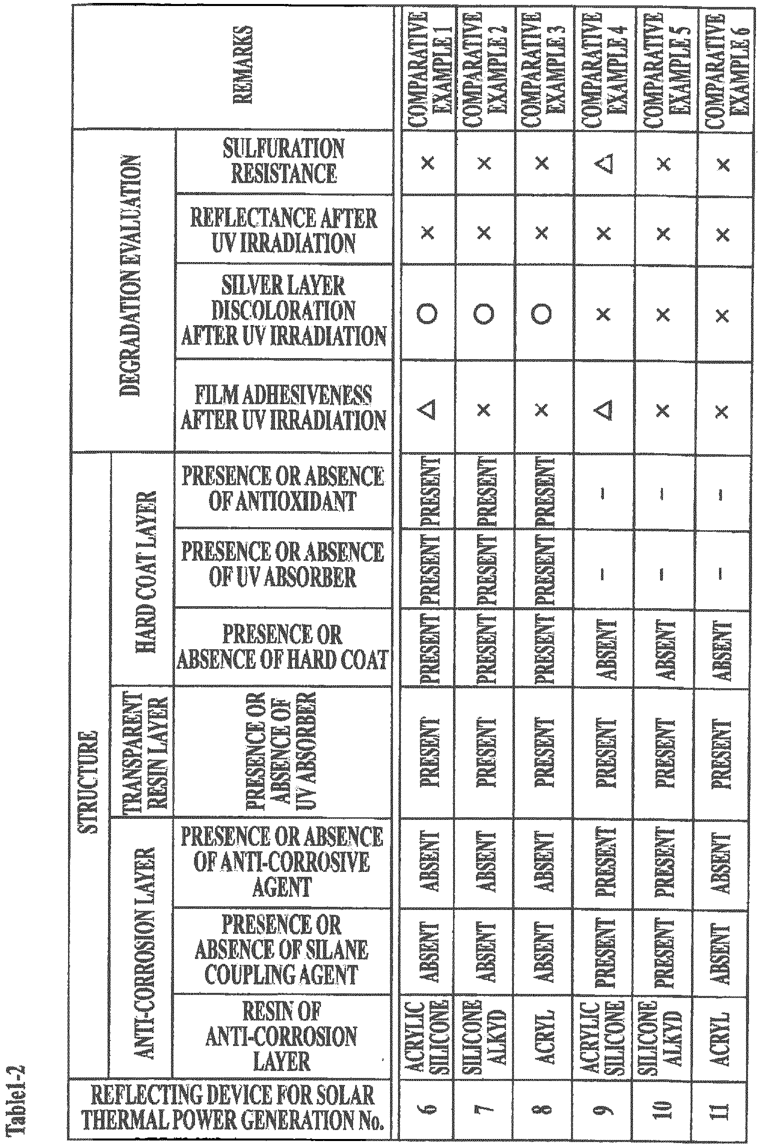

[Table 2]

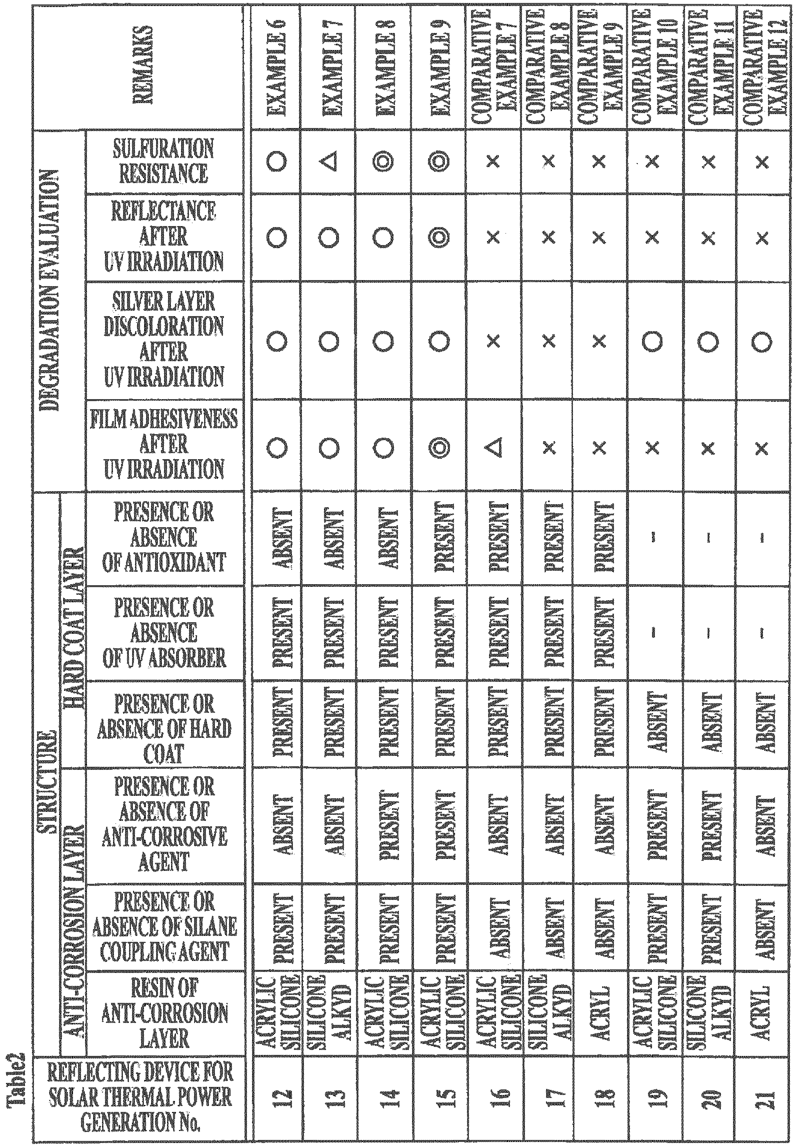

[Table 3-1]

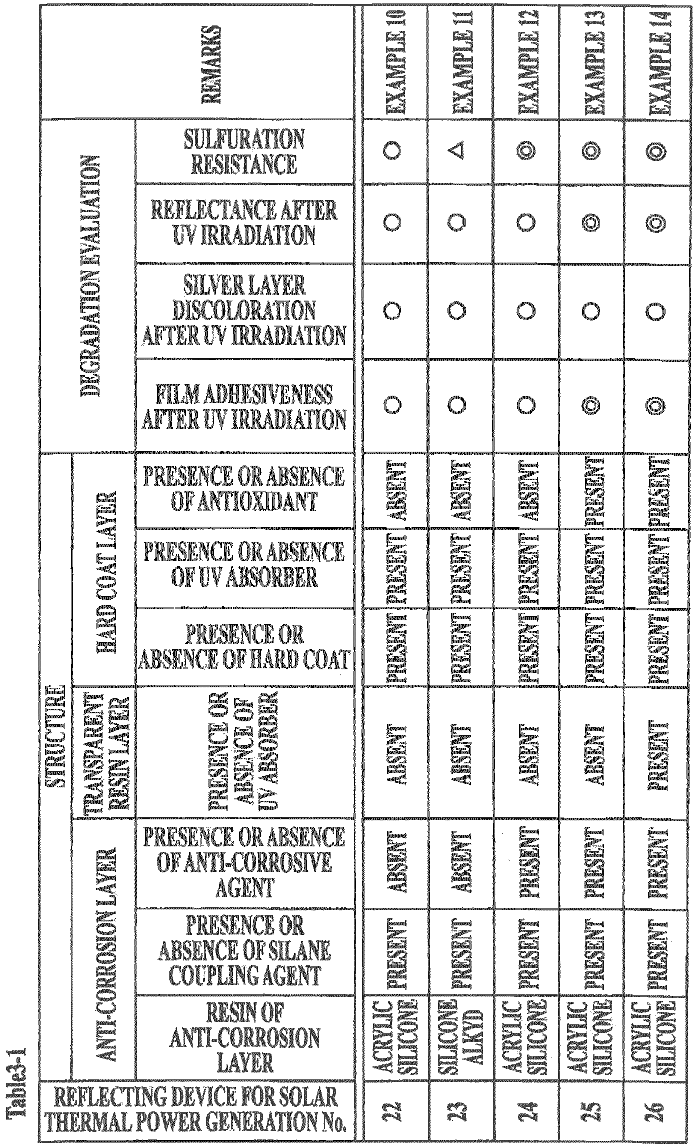

[Table 3-2]

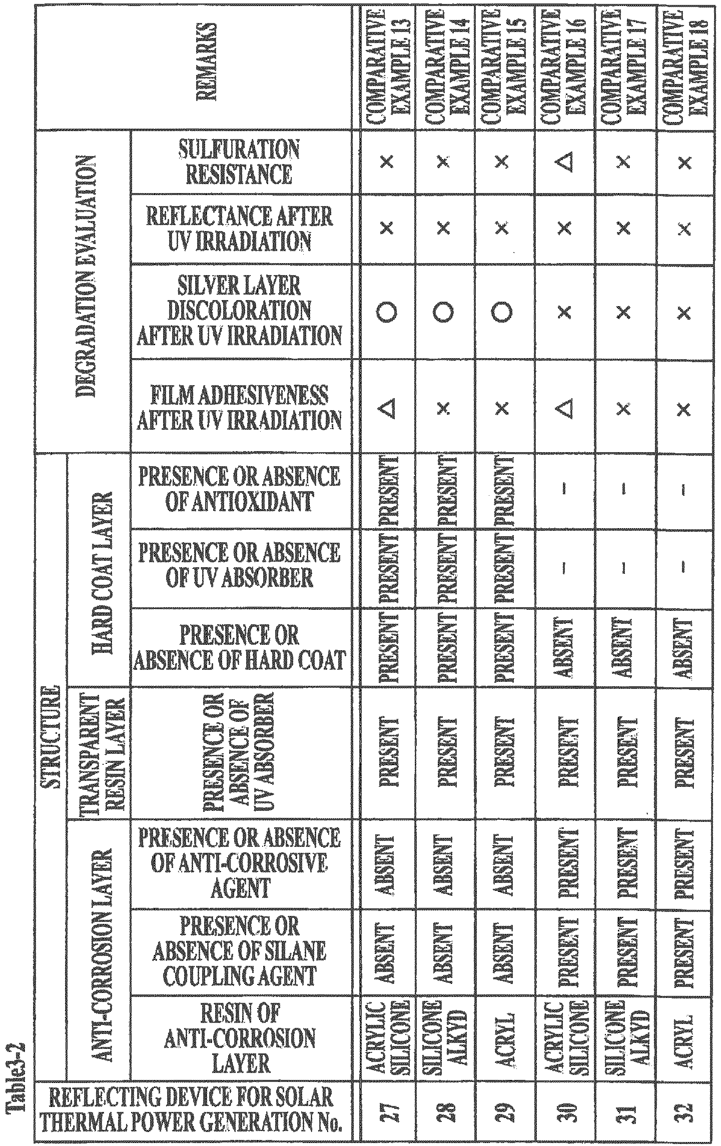

As is clear from Tables 1, 2 and 3, the film mirrors for solar thermal power generation No. 1-5, No. 12-15 and No. 22-26 according to the present invention, in which the anti-corrosion layer 6 composed of a silicone-modified resin and silane coupling agent is stacked on the reflective layer 5 and the hard coat layer 9 containing a UV absorber is provided at the outermost surface, can maintain film adhesiveness between the reflective layer 5 and the resin layer (anti-corrosion layer 6) even after UV degradation treatment and show no discoloration of the reflective layer 5, which prove good weather resistance.
It is verified from the film mirrors for solar thermal power generation No.4-5, No.15 and No.25-26 in which an antioxidant was added in the hard coat layer 9 that the film adhesiveness after UV irradiation was improved and that the reflectance after UV irradiation was improved due to suppression of yellowish- discoloration of the resin layer positioned on the light-incident side of the reflective layer 5 because oxidation-degradation of the UV absorber in the hard coat layer 9 was suppressed by the antioxidant.
According to the film mirrors for solar thermal power generation No.3-5, No.14-15 and No.24-26 in which corrosion preventing agent was added in the anti-corrosion layer 6, the sulfuration resistance was more improved.
It can be recognized that an acrylic silicone resin has higher sulfuration resistance than a silicone alkyd resin as a resin for the anti-corrosion layer 6 by comparing between the film mirrors for solar thermal power generation No.1 and No.2, and between No.22 and No.23.

On the other hand, the comparative film mirrors for solar thermal power generation No.6-11, No.16-21 and No.27-32 each of which lacks at least one of a silicone-modified resin, silane coupling agent and hard coat layer 9 containing UV absorber caused decrease of film adhesiveness and/or discoloration of the reflective layer 5 after UV irradiation. Therefore, they cannot be used outdoors for a long period.

As described above, the film mirror 10a, 10b and 10c of the present invention (film mirrors for solar thermal power generation No.1-5, No.12-15 and No.22-26) is light-weight, flexible and has high weather resistance, and the reflective layer 5 and the anti- corrosion layer 6 of the film mirror is not peeled off at the interface therebetween by washing after long time standing left outdoors. Therefore, the film mirror of the invention can be used as a film mirror having an excellent regular reflectance against sunlight.

### INDUSTRIAL APPLICABILITY

The present invention thus configured may be used as a film mirror and a reflecting device for solar thermal power generation.

### EXPLANATION OF SYMBOLS

1 support
2 sticky layer
3 base (film base)
4 anchor layer
5 reflective layer (silver layer)
6 anti-corrosion layer (corrosion prevention layer)
7 adhesive layer
8 transparent resin layer
9 hard coat layer
10a, 10b, 10c film mirror
201, 20b, 20c reflecting device for solar thermal power generation

## Claims

1. A film mirror wherein a reflective layer is provided over a film base, the film mirror comprising:
an anti-corrosion layer provided adjacent to the reflective layer on a light-reflecting side, and
a hard coat layer provided on the light-reflecting side of the anti-corrosion layer,
wherein the anti-corrosion layer is formed by comprising a silicone-modified resin and containing a silane coupling agent, and
the hard coat layer contains a UV absorber.

2. The film mirror of claim 1, wherein the hard coat layer is provided at an outermost surface on the light-reflecting side.

3. The film mirror of claim 1 or 2, wherein the silicone-modified resin is an acrylic silicone resin.

4. The film mirror of any one of claims 1 to 3, wherein the anti-corrosion layer contains a corrosion preventing agent.

5. The film mirror of any one of claims 1 to 4, wherein the hard coat layer contains an antioxidant.

6. The film mirror of any one of claims 1 to 5, wherein the reflective layer is a silver reflective layer.

7. A reflecting device for solar thermal power generation, wherein the device is formed by bonding the film mirror of any one of claims 1 to 6 to a support.

8. A functional film wherein a silver layer is provided over a film base, comprising:
an anti-corrosion layer provided adjacent to the silver layer on a reflecting side, and
a hard coat layer provided on the reflecting side of the anti-corrosion layer,
wherein the anti-corrosion layer is formed by comprising a silicone-modified resin and containing a silane coupling agent, and
the hard coat layer contains a UV absorber.
